# EUROPEAN PATENT APPLICATION

(11) **EP 4 521 859 A2**
(43) Date of publication of application: **12.03.2025**
(21) Application number: 24715701.9
(22) Date of filing: 04.04.2024
(51) Int. Cl.: H05K 1/18, H05K 1/11, H05K 3/34, H01L 23/498, H01L 23/482, H01L 25/065, H01L 25/18, H01L 23/00

(54) **PRINTED CIRCUIT BOARD ASSEMBLY AND MANUFACTURING METHOD THEREFOR**

(30) Priority: 07.07.2023 KR 20230088604; 10.08.2023 KR 20230104567
(71) Applicant: Samsung Electronics Co., Ltd., Suwon-si, Gyeonggi-do 16677 (KR)
(72) Inventor: KWON, Ohdae, Suwon-si, Gyeonggi-do 16677 (KR); PARK, Woochul, Suwon-si, Gyeonggi-do 16677 (KR); LEE, Cholhee, Suwon-si, Gyeonggi-do 16677 (KR); NAM, Hyungjong, Suwon-si, Gyeonggi-do 16677 (KR); MIN, Yousok, Suwon-si, Gyeonggi-do 16677 (KR); BYUN, Chansic, Suwon-si, Gyeonggi-do 16677 (KR)
(74) Representative: HGF
(86) International application number: PCT/KR2024/004433
(87) International publication number: WO 2025/014035

(57) **Abstract**

A printed circuit board (PCB) assembly according to an embodiment may comprise a PCB including a plurality of pads and a dummy pad and an electronic component including a plurality of contact points disposed on a bottom side of the electronic component, and the electronic component mounted on the PCB by soldering the plurality of contact points to the plurality of pads. The dummy pad, provided on the PCB, may have an elongated portion spaced apart from an outer edge of the electronic component.

## Description

### [Technical Field]

The disclosure relates to a printed circuit board assembly having electronic components that are mounted by soldering process and a method for manufacturing the same.

### [Background Art]

A rapid development of electronics industry and user demand lead to more compact, multi-functional electronic devices. Accordingly, the need for compact and multi-functional semiconductor devices used in electronic devices grows. In semiconductor devices, electronic components are soldered onto a substrate using a surface mount technology, and use a reflow process to heat and melt the solder paste. During the reflow process, the substrate may be partially bent as a result of a heating process.

### [Disclosure of Invention]

### [Solution to Problem]

Embodiments of the disclosure may maintain connection between an electronic component and a substrate although a portion of the substrate may be bent during the reflow process.

Various embodiments of the disclosure propose a printed circuit board (PCB) assembly having a dummy pad for preventing a solder cream (or solder paste), applied and soldered for mounting the electronic component, from being exposed or displaced to the outside of the electronic component and a method for manufacturing the same.

Various embodiments of the disclosure may prevent a short circuit between the electronic component and the substrate due to bending of the substrate during a reflow process when the electronic component is mounted on the substrate through a surface mount technology (SMT) process.

Various embodiments of the disclosure may prevent a short circuit that may be caused by solder ball escape or displacement due to bending of the substrate during the reflow process when the electronic component is mounted on the substrate through the SMT process.

Various embodiments of the disclosure may prevent an increase in current consumption and performance deterioration due to a short circuit between the electronic component and the substrate even when a portion of the substrate bends or sags during the manufacturing process.

A PCB assembly according to an example embodiment of the disclosure, may comprise a PCB including a plurality of pads and a dummy pad, and an electronic component, including a plurality of contact points disposed on a bottom side of the electronic component, and the electronic component mounted on the PCB, by soldering the plurality of contact points to the plurality of pads. The dummy pad, provided on the PCB, may have an elongated portion spaced apart from an outer edge of the electronic component.

A method of manufacturing a PCB assembly, according to an example embodiment, may comprise: providing a dummy pad, supported by a dummy substrate via a plurality of bridge sections, on the PCB which includes a plurality of pads; applying solder material over each of the plurality of pads on the PCB such that solder material is eccentrically disposed with respect to one of the pads in a direction towards the dummy pad; and mounting an electronic component including a plurality of contact points, disposed on a bottom side of the electronic component, on the PCB by soldering the plurality of contact soldered to the plurality of pads. The dummy pad may have an elongated portion spaced apart from an outer edge of the electronic component for attaching to a portion of solder material which was detached during the soldering of the plurality of contact points of the electronic component to the plurality of pads of the PCB.

According to various embodiments of the disclosure, the PCB assembly may decrease a manufacture defect rate of the PCB assembly by placing the dummy pad around the connection pad positioned in an area where a bend may occur during the reflow process.

According to various embodiments of the disclosure, the PCB assembly may prevent a solder ball from escaping to cause a short circuit to another neighboring electronic component by placing the dummy pad around one connection pad, although a soldering material (e.g., solder paste) may be overapplied on the one connection pad.

According to various embodiments of the disclosure, the PCB assembly may secure electrical performance of various electronic components (e.g., ball grid array (BGA), land grid array (LGA), or micro interconnection (MIC)-type electronic components) disposed near the edge of the substrate.

According to various embodiments of the disclosure, by distributing the soldering material between the connection pad and the dummy pad, solder ball escape to the outside of the connection pad may be stopped, thereby preventing a short circuit between the electronic component and the substrate.

Effects of the disclosure are not limited to the foregoing, and other unmentioned effects would be apparent to one of ordinary skill in the art from the following description. In other words, unintended effects in practicing embodiments of the disclosure may also be derived by one of ordinary skill in the art from the embodiments of the disclosure.

### [Brief Description of Drawings]

FIG. 1 is a perspective view illustrating an example printed circuit board assembly according to various embodiments;
FIG. 2 is a plan view illustrating part A of FIG. 1;
FIG. 3A is a plan view illustrating part A of FIG. 1 without a first electronic component;
FIG. 3B is a cross-sectional view taken along line B-B' of FIG. 3A;
FIG. 4A is a plan view illustrating an example printed circuit board assembly according to various embodiments;
FIG. 4B is a view illustrating a first substrate mounted on an electronic device according to various embodiments;
FIGS. 5A, 5B, and 5C are views illustrating example processes for manufacturing a printed circuit board assembly according to various embodiments;
FIGS. 6A, 6B, and 6C are views illustrating occurrence of bending during a reflow process in a printed circuit board assembly according to various embodiments;
FIG. 7 is a flowchart illustrating an example method for manufacturing a printed circuit board assembly according to various embodiments;
FIG. 8 is a plan view illustrating an example substrate according to various embodiments;
FIG. 9 is a view illustrating various shapes of a dummy pad in a printed circuit board assembly according to various embodiments;
FIGS. 10A and 10B are plan views illustrating an example substrate according to various embodiments;
FIGS. 11A, 11B, and 11C are plan views illustrating an example substrate according to various embodiments;
FIG. 12 is a plan view illustrating an example substrate according to various embodiments;
FIG. 13 is a side view illustrating an example printed circuit board assembly according to various embodiments;
FIG. 14 is a side view illustrating an example printed circuit board assembly according to various embodiments;
FIGS. 15A and 15B are cross-sectional views illustrating an example substrate according to various embodiments; and
FIGS. 16A, 16B, 16C, and 16D are views illustrating a conventional printed circuit board assembly that lacks a dummy pad according to a prior art.

Reference may be made to the accompanying drawings in the following description, and specific examples that may be practiced are shown as examples within the drawings. Other examples may be utilized and structural changes may be made without departing from the scope of the various examples.

### [Mode for the Invention]

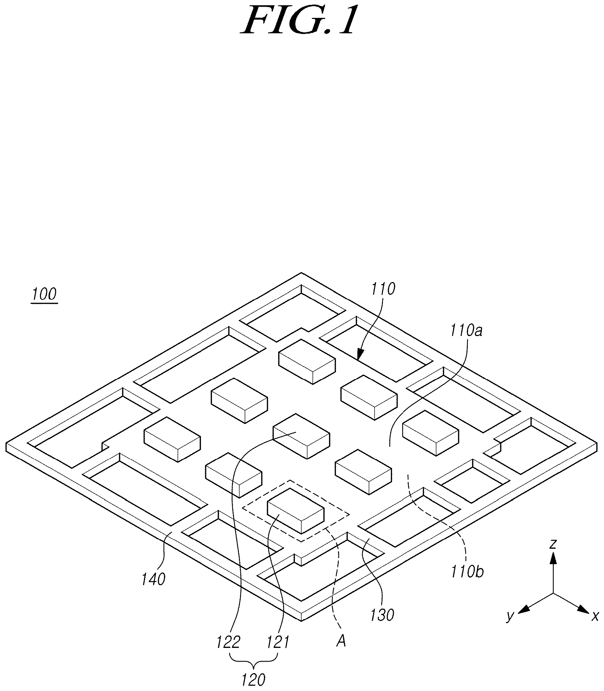

Various embodiments of the disclosure are merely exemplified herein with reference to FIGS. 1 to 16D, to describe the principle of the disclosure, and should not be interpreted as limiting the scope of the disclosure. Those skilled in the art will understand that the principle of the disclosure may be implemented in any appropriately disposed system or device.

Embodiments of the disclosure are now described with reference to the accompanying drawings in such a detailed manner as to be easily practiced by one of ordinary skill in the art. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

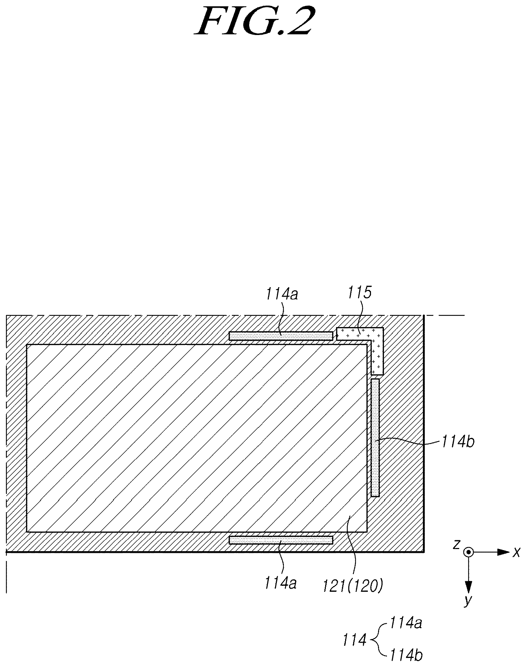

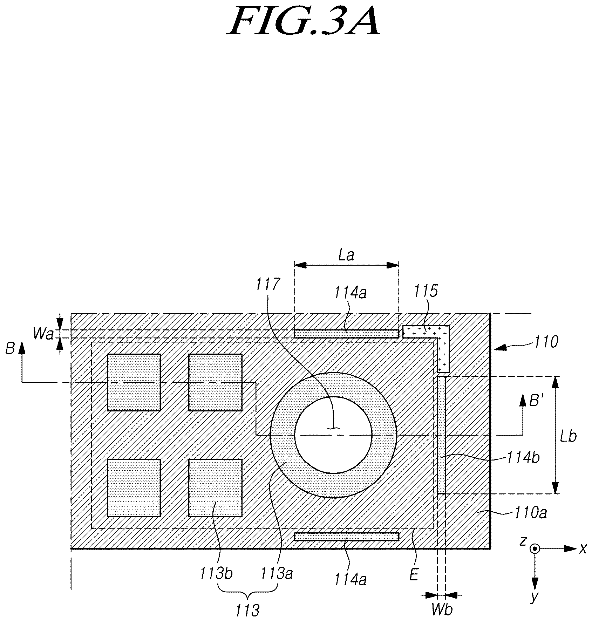

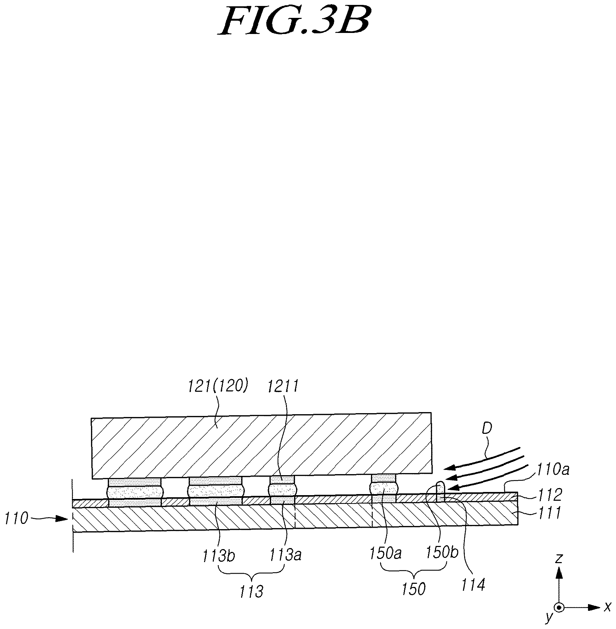

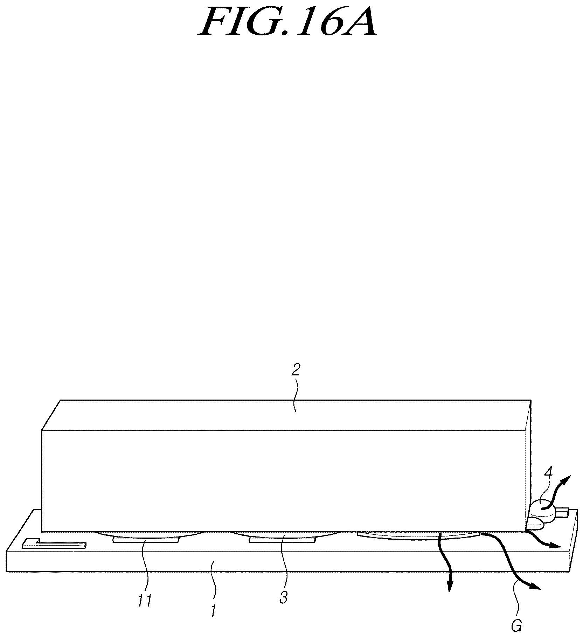

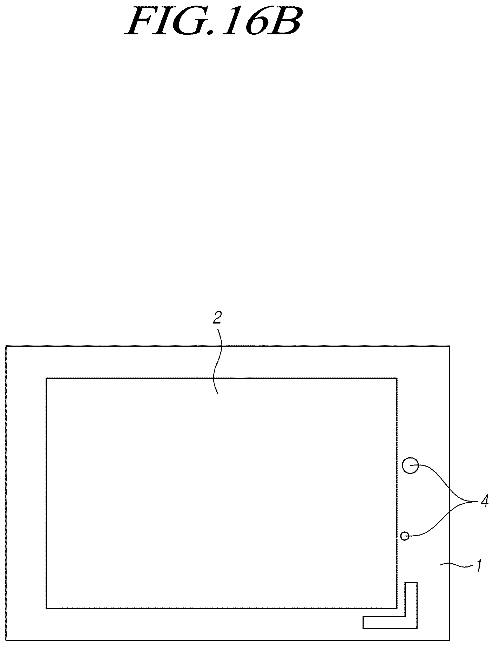

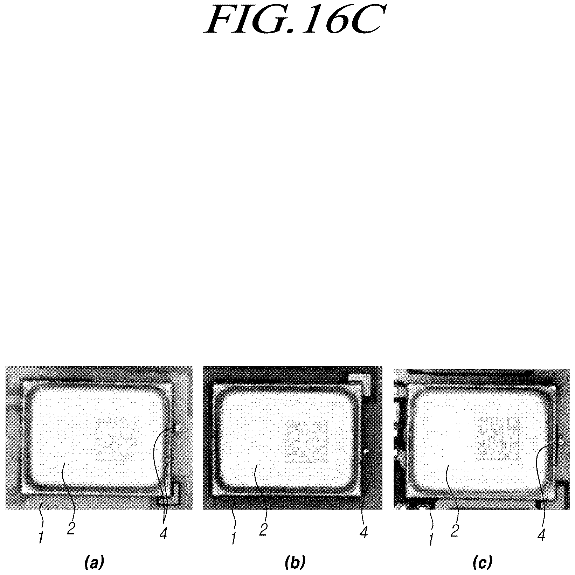

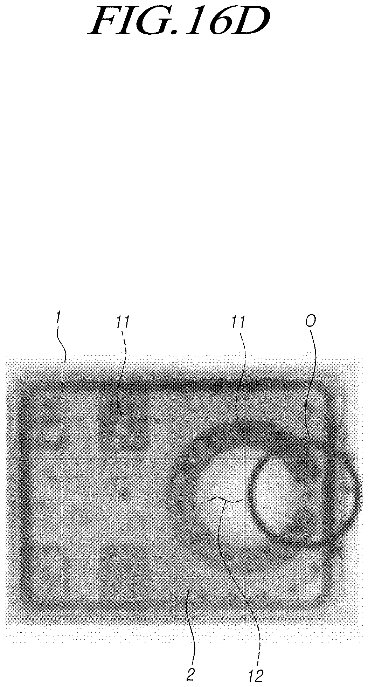

FIG. 1 is a perspective view illustrating an example printed circuit board assembly according to various embodiments. FIG. 2 is a plan view illustrating part A of FIG. 1. FIG. 3A is a plan view illustrating part A of FIG. 1 without a first electronic component. FIG. 3B is a cross-sectional view taken along line B-B' of FIG. 3A. FIGS. 16A, 16B, 16C, and 16D are views illustrating a conventional printed circuit board assembly that lacks a dummy pad according to a prior art.

Referring to FIGS. 1 to 3B, a PCB assembly 100 may include all or some of a PCB 110, an electronic component 120, a dummy substrate 140, and/or a solder ball 150. The PCB assembly 100 may be, e.g., a module such as a solid state drive (SSD) module, a memory module, a computer system module, or a mobile system module. The PCB assembly 100 may be a semiconductor substrate. In the following description, the PCB assembly 100 will be specifically described as a semiconductor substrate, but the proposed structure or manufacturing method thereof may not be specifically applied only to the semiconductor substrate, but may be applied to all PCB assemblies made by preparing or mounting electronic components using a soldering process.

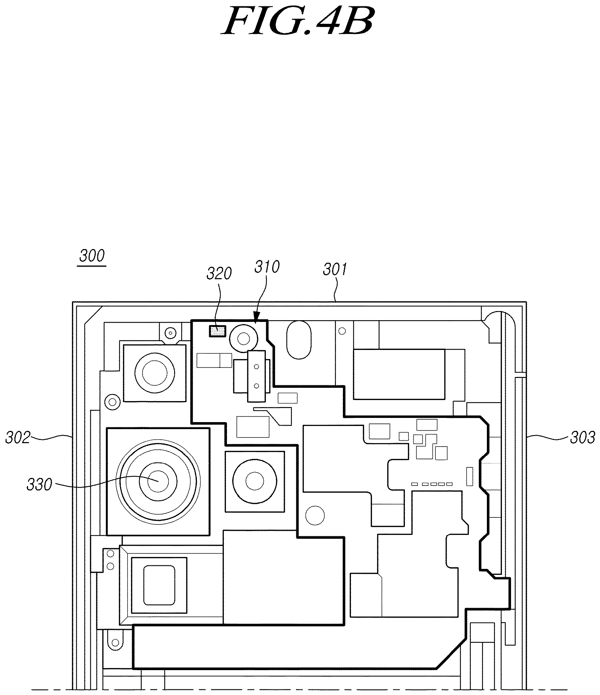

The electronic component 120 may be mounted on the PCB 110. The PCB 110 may be mounted on an electronic device (e.g., the electronic device 300 of FIG. 4B). The electronic component 120 may not be mounted on the dummy substrate 140. The dummy substrate 140 may be removed in the final step of the manufacturing process. The dummy substrate 140 may be provided to support or secure the PCB 110. The dummy substrate 140 may also be referred to as a support substrate. The PCB 110 and the dummy substrate 140 may be connected by at least one bridge section 130. The bridge section 130 may be cut, severed, or removed in the final step of the manufacturing process. For example, the PCB 110 may be separated from the dummy substrate 140 by cutting, severing, or removing the bridge section 130.

Dust (or fine dust) may be generated when the bridge section 130 is cut or severed. Since the dust generated from cutting the bridge section 130 may flow or migrate between the PCB 110 and the electronic component 120 and cause defects to occur, a number of bridge sections at appropriate (e.g., predetermined) positions may be placed to prevent and/or reduce defects The bridge section 130 may also be referred to as a support member. The PCB 110 may be configured to mount (or prepare) at least one electronic component 120 on at least one of the upper side 110a and/or the lower side 110b by soldering. The PCB 110 may be made of various types of substrates (e.g., ceramic substrates, PCBs, or flexible substrates) well known in the art. Although not illustrated, a wiring pattern for electrically connecting the connection pads 113 may be formed on at least one of the upper side 110a and the lower side 110b of the PCB 110.

According to an embodiment, the PCB 110 may include at least one of a body 111, a protective layer 112, a connection pad 113, a dummy pad 114, or a guideline 115. The PCB 110 may be divided into a single layer PCB having circuit lines formed on only one surface and a double layer PCB having circuit lines formed on two opposite surfaces. In the case of the double layer PCB, upper and lower circuit lines may be electrically connected through a conductive via penetrating the body 111.

The body 111 may include a glass epoxy (or FR-4) resin, a phenol resin, or a bismaleimide triazine resin. The body 111 may include a body layer compressed to a predetermined thickness and a circuit line formed on the body layer. The circuit line may be formed by patterning a copper foil coated on the body layer.

The body 111 may have a structure in which three or more layers of the copper foil are formed using an insulator called a prepreg and a circuit line connected in three or more layers along the number of layers of the copper foil but is not limited thereto.

The protective layer 112 may be formed of a material (e.g., solder resist) covering the circuit line. The protective layer 112 may have a structure in which the circuit line is covered while the connection pad 113 is not covered. The PCB 110 may be configured to be solder resist processed around the dummy pad 114.

The connection pad 113 may be formed as a part of or separately on the circuit line. The connection pad 113 may be referred to as an electrode pad, a substrate pad, a contact pad, a solder pad, or a soldering pad. The connection pad 113 may be formed of, e.g., at least one of aluminum (Al), copper (Cu), nickel (Ni), tungsten (W), platinum (Pt), or gold (Au). A conductive layer used for micro bumps, wire bonding, or the like may be referred to as a pad, and a conductive layer used for a larger solder ball or the like may be referred to as a land, but hereinafter, they are collectively referred to as a connection pad.

The plurality of connection pads 113 may be provided to be electrically connected to the electronic component 120. The plurality of connection pads 113 may be disposed on the body 111. The plurality of connection pads 113 may be disposed on substantially the same plane as the protective layer 112 but are not limited thereto. The plurality of connection pads 113 may be disposed on at least one of the upper side 110a or the lower side 110b of the PCB 110. Although not illustrated, the plurality of connection pads 113 may be provided to be electrically connected to other substrates in addition to the electronic component 120.

The plurality of connection pads 113 electrically connected to the electronic component 120 may be positioned below the electronic component 120. The plurality of connection pads 113 may be disposed to overlap(or cover), e.g., the electronic component 120. As illustrated in FIG. 2, the plurality of connection pads 113 may be disposed not to be visible by the electronic component 120 when viewed from the upper side to the lower side (e.g., in the -z-direction). For example, the plurality of connection pads 113 electrically connected to the first electronic component 121 may be disposed not to protrude or extend from the PCB 110 to the outside of the first electronic component 121.

As illustrated, the connection pads 113 may include a first connection pad 113a that is hollow and circular shaped (e.g., a ring shape) or a second connection pad 113b that is rectangular shaped. However, this is merely an example, and the shape of the connection pad 113 is not limited by the illustrated shape, and various shapes may be applied to the connection pad 113.

For example, the PCB 110 may include an opening 117 formed by penetrating a portion corresponding to the hollow portion of the first connection pad 113a. The opening 117 may be formed to penetrate the substrate vertically (e.g., in the z-direction). For example, if the first electronic component 121 is a microphone element, sound may be introduced into the first electronic component 121 through the opening 117. The first electronic component 121 may have a recess formed inward, at a position corresponding to the opening 117 of the PCB 110. The recess of the first electronic component 121 may be formed to detect a sound introduced through the opening 117.

For example, the plurality of connection pads 113, electrically connected to the first electronic component 121, may be disposed inside the edge virtual line E of FIG. 3 which indicates the edge of an electronic component (e.g., the first electronic component 121) when the electronic component (e.g., the first electronic component 121) is mounted on the PCB 110. For example, the plurality of connection pads 113, electrically connected to the first electronic component 121, may be disposed not to protrude (or extend) beyond(or outside) the edge virtual line E. For example, the plurality of connection pads 113, electrically connected to the first electronic component 121, may be disposed not to cover or overlap the edge virtual line E. In other words, for example, the plurality of connection pads 113 may be disposed to stay within the boundary of the edge virtual line E. The area formed (or marked) by the edge virtual line E may refer to an overlapping area between the first electronic component 121 and the PCB 110.

The dummy pad 114 may be provided on the PCB 110. The dummy pad 114 may have a rectangular shape. The dummy pad 114 may be disposed on the outside of the structural boundary of the electronic component 120. The structural boundary of the electronic component 120 may refer to the borders, limits, or edges of the electronic component 120 when viewed from the top or in a downward direction (e.g., -z-axis direction). For example, the dummy pad 114 may be disposed on the outside of the structural boundary of the first electronic component 121 in the horizontal direction, spaced apart from the first electronic component 121. The dummy pad 114 may be disposed next to or near an electronic component (e.g., the first electronic component 121), which is disposed adjacent (or close) to an edge of the PCB 110. The dummy pad 114, disposed next to the electronic component 120, may be visible when viewed in a downward direction (e.g., in the -z-direction).

The dummy pad 114 may be configured to extend in a parallel direction to one of the edges of the first electronic component 121. For example, the dummy pad 114(e.g., the longer side of the dummy pad having a rectangular shape) may be disposed to run parallel to the lateral side of the first electronic component 121 on the PCB 110. For example, the dummy pad 114 may be configured to extend in a direction parallel to the lateral side of the first electronic component 121 on the PCB 110. The corner of the first electronic component 121 may include a three-dimensional corner object or part. The three-dimensional corner object may be provided, e.g., where the front side contacts the lateral sides. The dummy pad 114 may have a certain length disposed along the lateral side of the first electronic component 121. A width of the dummy pad 114 may be shorter compared to a length thereof. The dummy pad 114 may have, e.g., a substantially rectangular shape. The length of the dummy pad 114 may have a length corresponding to 5% to 100% of the length of the lateral side of the first electronic component 121 extending substantially parallel to the dummy pad 114. For example, the dummy pad 114 may have a length of 15% to 35% of the length of the lateral side of the first electronic component 121. For example, the dummy pad 114 may have a length of 25% to 60% of the length of the lateral side of the first electronic component 121.

For example, the dummy pad 114 may have a substantially rectangular shape extending in a substantially parallel direction to the length direction of the lateral side of the first electronic component 121.

The dummy pad 114 may include a first dummy pad 114a and a second dummy pad 114b. When the first dummy pad 114a and the second dummy pad 114b are disposed on the outside of the structural boundary of the first electronic component 121 as illustrated, the first dummy pad 114a and the second dummy pad 114b need to be disposed in an appropriate size in consideration of the distance from other adjacent electronic components. In particular, in order to mount high density electronic components on the PCB 110, the dummy pad 114a may be designed to have a certain or predetermined size.

The first dummy pad 114a may extend in a substantially parallel direction to a longer lateral side of the first electronic component 121. Two first dummy pads 114a may be disposed to be spaced apart from two longer lateral sides of the first electronic component 121. For example, the length La of the first dummy pad 114a may be 0.88 mm to 1.32 mm. For example, the length La of the first dummy pad 114a may be 1.10 mm. For example, the length La of the first dummy pad 114a may have a length of 25% to 38% of the length of the longer lateral side among the lateral sides of the first electronic component 121. For example, the width or thickness Wa of the first dummy pad 114a may be 0.08 mm to 0.12 mm. For example, the width or thickness Wa of the first dummy pad 114a may be 0.10 mm.

The second dummy pad 114b may extend in a substantially parallel direction to a shorter lateral side of the first electronic component 121. For example, the length Lb of the second dummy pad 114b may be 1.24 mm to 1.86 mm. For example, the length Lb of the second dummy pad 114b may be 1.55 mm. For example, the length Lb of the second dummy pad 114b may be 46% to 70% of the length of the shorter lateral side of the first electronic component 121. For example, the width or thickness Wb of the second dummy pad 114b may be 0.08 mm to 0.12 mm. For example, the width or thickness Wb of the second dummy pad 114b may be 0.10 mm.

As illustrated, the widths of the first dummy pad 114a and the second dummy pad 114b may be formed to be thin, thereby efficiently securing a space on the PCB 110 even when high-density electronic components are mounted.

The dummy pad 114 may be disposed on the outside of the edge virtual line E. For example, the dummy pad 114 may be disposed to be spaced apart (e.g., distanced) from the edge virtual line E by a predetermined interval (or distance). In this case, the dummy pad 114 may not have an area substantially overlapping the inner area of the edge virtual line E. For example, the dummy pad 114 may be disposed to be spaced apart from the edge virtual line E by the distance (or width) of 0.01 mm or less. The distance (or width) between the dummy pad 114 and the edge virtual line E may be up to 0.01 mm. However, the disclosure is not limited thereto, and the dummy pad 114 may be disposed to be spaced apart from the edge virtual line E by the distance (or width) of 0.01 mm to 0.04 mm or may be disposed inside the edge virtual line E. For example, even when the dummy pad 114 is disposed inside the edge virtual line E, the dummy pad 114 may be disposed between the connection pad 113 and the edge virtual line E.

The dummy pad 114 may be disposed not to overlap with the first electronic component 121. For example, the dummy pad 114 may be disposed not to overlap or cover the corner of the first electronic component 121. For example, the dummy pad 114 may be disposed not to overlap or cover the edge virtual line E. The dummy pad 114 may be disposed between a lateral side of the first electronic component 121 and an edge of the PCB 110.

The dummy pad 114 may be disposed adjacent to one connection pad (e.g., the first connection pad 113a) among the plurality of connection pads 113. For example, the one connection pad (e.g., the first connection pad 113a) may refer to a connection pad in which bending (or deformation) of the PCB 110 occurs in a reflow process, potentially causing a short circuit to occur. A distance (or width) between the one connection pad (e.g., the first connection pad 113a) and the dummy pad 114 may be 0.2 mm to 0.8 mm. However, the disclosure is not limited thereto.

The dummy pad 114 may be disposed in a section or part of the PCB adjacent or close to an edge or a corner. During the reflow process, the edge or corner section or part of the PCB 110 may be bent or deformed due to high temperature. Thus, the dummy pad 114 may be disposed adjacent or close to the edge or corner of the PCB 110 to prevent a short circuit from occurring in the connection pad (e.g., the first connection pad 113a) or to prevent the solder excess from escaping to the surroundings. For example, the dummy pad 114 may be disposed between the first electronic component 121, mounted near the edge or corner of the PCB 110, and the edge or corner of the PCB 110. For example, the dummy pad 114 may be disposed on the outside of the structural boundary of the first electronic component 121, mounted near the edge or corner of the PCB 110 adjacent to the first electronic component 121. For example, the dummy pad 114 may be disposed between the edge virtual line E and the adjacent edge or corner of the PCB 110. However, the position of the dummy pad 114 is not limited thereto.

The surface of the dummy pad 114 may be soldered. The dummy pad 114 may be soldered in a manufacturing process without having the connection pad 113 or the contact point 1211electrically connected.

The dummy pad 114 may be formed of, e.g., at least one of aluminum (Al), copper (Cu), nickel (Ni), tungsten (W), platinum (Pt), or gold (Au). For example, the dummy pad 114 may have substantially the same or similar material as/to the connection pad 113.

The dummy pad 114 may be provided to attach a part of the soldering material which escapes during the process of soldering the plurality of contact points 1211 of the first electronic component 121 and the plurality of pads 113 of the PCB 110. The dummy pad 114 may have an elongated portion spaced apart from an outer edge of the first electronic component 121. For example, the dummy pad 114 may have an elongated shape.

The PCB 110 may include at least one dummy pad 114, disposed in different directions with respect to a connection pad (e.g., the first connection pad 113a). For example, as illustrated, the at least one dummy pad 114 may be provided in each of an upper direction (e.g., - y-direction), a right direction (e.g., +x-direction), and a lower direction (e.g., +y-direction) with respect to the first connection pad 113a. Each of the at least one dummy pad 114 may be formed to extend in a direction parallel to the edge of the electronic component 120. For example, although not illustrated, only one dummy pad 114 may be disposed in one of an upper direction (e.g., -y-direction), a right direction (e.g., +x- direction), or a lower direction (e.g., +y-direction) with respect to the first connection pad 113a.

The dummy pad 114 may be electrically separated or independent from the connection pad 113. The dummy pad 114 may be electrically separated from an electronic component (e.g., the first electronic component 121). For example, the circuit line for electrical connection may be omitted from the dummy pad 114. The dummy pad 114 may be configured to be electrically independent from the connection pad 113. For example, the dummy pad 114 may have an electrical or circuit-wise blocking design structure.

The solder balls 150 may include a first solder ball 150a and a second solder ball 150b. The first solder ball 150a may refer to a solder ball disposed on the connection pad 113. The second solder ball 150b may refer to a solder ball disposed on the dummy pad 114. The first solder ball 150a and the second solder ball 150b may be disposed on the connection pad 113 and the dummy pad 114 by the SMT process described below.

The second solder ball 150b disposed on the dummy pad 114 may prevent water, dust, or foreign matter D from entering or moving into a space between the first electronic component 121 and the PCB 110. As the second solder ball 150b forms a wall, water, dust, or foreign matter D may be prevented from moving around the connection pad 113 to cause a short circuit. For example, as described below, dust is generated in the process of cutting or severing the bridge section 130, and the dust may move toward the first electronic component 121 disposed adjacent to the edge. The second solder ball 150b may serve as a wall for preventing such dust from flowing or moving into the lower side of the first electronic component 121.

The area(and/or the surface area) of the dummy pad 114 may be smaller than the area of one adjacent connection pad (e.g., the first connection pad 113a). For example, the area(and/or the surface area) of the dummy pad 114 may be 30% or less than the area of one adjacent connection pad (e.g., the first connection pad 113a). For example, the area of the dummy pad 114 may be 10% or more than the area of one adjacent connection pad (e.g., the first connection pad 113a). Accordingly, the size of the first solder ball 150a provided on one connection pad (e.g., the first connection pad 113a) may be larger than the size of the second solder ball 150b provided on the dummy pad 114. The first solder ball 150a provided on one connection pad 113 may be formed to electrically connect the corresponding connection pad 113 and the contact point 1211, which is an electrical terminal provided on the corresponding electronic component 120. Here, the contact point 1211 may include a pad.

The guideline 115 may be a mark line to provide guidance to the electronic component 120 to be mounted in the correct position. The guideline 115 may be disposed on the outside of the structural boundary of the electronic component 120, e.g., a corner portion of the edge virtual line E.

The electronic component 120 may be mounted on at least one of the upper side 110a or the lower side 110b of the PCB 110. Here, the upper side 110a of the PCB 110 may refer to a surface in a direction (e.g., +z-direction) toward the electronic component 120 in the figures. Here, the lower side 110b of the PCB 110 may refer to a surface in the opposite direction (e.g., -z-direction) of the electronic component 120. FIG. 1 illustrates an example in which the electronic component 120 is mounted on the upper side 110a of the PCB 110. However, the disclosure is not limited thereto, and the electronic component 120 may be mounted on the lower side 110b of the PCB 110. Although not illustrated, the electronic component 120 may be of various sizes or shapes and may be disposed in various shapes on two opposite surfaces of the PCB 110 according to the design of the PCB assembly 100. The electronic component 120 may include various elements such as a passive element and an active element, and any element that may be mounted on the PCB 110 may be used as an electronic component.

The electronic components 120 may include a first electronic component 121 or a second electronic component 122. The first electronic component 121 may be an element disposed relatively closer to the edge of the PCB 110 than the second electronic component 122. For example, the first electronic component 121 may be a component disposed relatively closer to a corner portion of the PCB 110 than the second electronic component 122. According to an embodiment, the dummy pad 114 may be provided closer to the first electronic component 121 than to the second electronic component 122. The first electronic component 121 may be an element disposed at a section or part where bending occurs on the PCB 110 as a result of a reflow process during a manufacturing process of the PCB assembly 100. The second electronic component 122 may be an element disposed at a section or part where bending does not occur on the PCB 110 as a result of the reflow process during the manufacturing process of the PCB assembly 100. The first electronic component 121 may be disposed at a section or part where bending occurs when high heat is applied to the PCB 110. The second electronic component 122 may be disposed at a section or part where bending does not occur when heat is applied to the PCB 110.

The electronic component 120 may include at least one contact point 1211. At least one contact point 1211 may be a portion provided to be electrically connected to the plurality of connection pads 113 through the at least one solder ball 150.

The electronic component 120 may be a chip package including at least one semiconductor chip therein. For example, the electronic component 120 may include at least one memory chip or logic chip therein. For example, when the electronic component 120 includes a memory chip, the electronic component 120 may be a memory device including a memory such as a DRAM, an SRAM, a flash memory, an EEPROM, a PRAM, an MRAM, or an RAM. When the electronic component 120 includes a logic chip, the electronic component 120 may be a logic element including a logic chip having a relatively small size.

The electronic component 120 may include an element such as a connector, a controller, or an electrolytic cap. Here, the electrolytic cap is a unipolar capacitor, has a large capacitance and may be used for a low frequency filter or a bypass.

The electronic component 120 may generally include a large-sized chip package such as a microprocessor, a central processing unit, a controller, or an application specific integrated circuit.

The electronic component 120 may include a system on chip (SoC) type application processor used in a mobile electronic device.

The type of the electronic component 120 is not limited to the above-described elements.

The electronic component 120 may be mounted on the PCB 110 through the SMT process. The SMT process may refer to a soldering technique in which an electronic device component is mounted on the surface of the PCB 110 and attached using a soldering material (or solder paste). For example, the SMT may refer to a technology for automatically mounting electronic components, such as semiconductors, diodes, and chips, on a substrate using a soldering material with equipment, such as a chip mounter or a release mounter, and curing the same. In such SMT process, heat and pressure may be applied to easily attach the corresponding electronic component with a soldering material. A reflow process (or reflow soldering) may occur in which the soldering material is melted by the applied heat and pressure. Accordingly, the SMT process may include a reflow process.

For example, the first electronic component 121 may be a microphone element. The first electronic component 121 (e.g., a microphone element) may be disposed adjacent to an edge of the PCB 110. If the first electronic component 121(e.g., the microphone element) is mounted on the substrate, the first electronic component 121 may receive sound from the outside through the opening 117 of the PCB 110. If a part of the soldering portion or section between the first connection pad 113a and the first electronic component 121 (e.g., a microphone element) is detached, a space may be formed due to detachment. An external sound may be introduced into the space, formed by the detachment, which may act as noise. According to various embodiments of the disclosure, it is possible to prevent a detachment between the first electronic component 121(e.g., a microphone element) and the first connection pad 113a as described below.

The first electronic component 121 may be mounted on the PCB 110 using the SMT process, which involves soldering the plurality of contact points 1211 disposed on the lower side of the first electronic component 121 and the plurality of pads 113 disposed on the PCB 110. The dummy pad 114 may be configured to attach the soldering material and detached while the first electronic component 121 is mounted on the PCB 110.

The PCB assembly 100 may include at least one solder ball 150. The solder balls 150 may include a first solder ball 150a, disposed on the connection pad 113, and a second solder ball 150b, disposed on the dummy pad 114.

The first solder ball 150a may be disposed between the contact point 1211 of the electronic component 120 and the connection pad 113 of the PCB 110. The first solder ball 150a may be configured to electrically connect the contact point 1211 and the connection pad 113. The first solder ball 150a may be disposed below the electronic component 120. The first solder ball 150a may be disposed to be not visible when viewed directly from the upper side(e.g., the -z-direction or from the top) of the PCB assembly.

The second solder ball 150b may be disposed on the dummy pad 114. The second solder ball 150b may be disposed to be spaced apart (e.g., predetermined distance or width) from the contact point 1211. The second solder ball 150b may be disposed not to be connected to an electronic component (e.g., the first electronic component 121). The second solder ball 150b may be disposed to be visible when viewed directly from the upper side (e.g., the -z-direction, or from the top) of the PCB assembly 100, but is not limited thereto. The second solder ball 150b may have a substantially semicircular shape. For example, the upper (e.g., +z-axis) side of the second solder ball 150b may be curved.

As illustrated in FIG. 3B, the second solder ball 150b may be disposed on the outside of the structural boundary of the electronic component 120, where as the first solder ball 150a is disposed within (or inside) the structural boundary of the electronic component 120, in order to prevent foreign substances, such as dust, from entering the inside. The second solder ball 150b may prevent foreign substances, such as dust, from entering the space formed between the electronic component 120 and the PCB 110.

The PCB assembly 100 may further include a bridge section 130 for supporting the PCB 110. The bridge section 130 may be connected to an edge of the PCB 110 to support or secure the PCB 110. The bridge section 130 may be integrally coupled with the PCB 110. The bridge section 130 may be cut or severed after the mounting of electronic components on the PCB 110 is completed.

FIGS. 16A to 16D illustrate a conventional PCB assembly structure that lacks a dummy pad. FIG. 16A is a perspective view illustrating a state in which a solder ball escapes. FIG. 16B is a plan view illustrating a state in which a solder ball escapes. (a), (b), and (c) of FIG. 16C illustrate actual examples in which a solder ball escapes. FIG. 16D illustrates an actual example in which a short circuit occurs. The electronic component 2 illustrated here may be a microphone element having a substantially circular recess formed in a partial area.

Referring to FIGS. 16A, 16B, and 16C, an electronic component 2 is mounted on a substrate 1 by the SMT process, and the substrate 1 and the electronic component 2 are electrically connected by a solder ball 3. After the electronic component 2 is mounted on the substrate 1 with the semi-liquid soldering material applied, soldering is performed through a high temperature reflow process. In this case, as the gas G or the like is generated and a portion(or section or part) of the substrate 1 may be bent, deformed, or sags, thereby allowing a portion(or amount) of the solder ball 4 to escape or move away from the electronic component 2, which can result in less solder on the actual pad, potentially causing a short circuit due to poor interconnection between the electronic component and the pad. In the disclosure, as illustrated in FIGS. 1 to 3B and FIGS. 5A to 15B, a dummy pad (e.g., the dummy pad 114 of FIG. 2) may be provided to prevent the solder ball from escaping, thereby preventing poor interconnection which can cause a short circuit.

Referring to FIG. 16D, an example in which a short circuit occurs between the electronic component 2 and a connection pad 11 of the substrate 1 is illustrated. When the substrate 1 is exposed to a high temperature environment during the reflow process for soldering, bending may occur and further may cause a short circuit to occur in the area O adjacent to the edge. The electronic component 2, (e.g., a microphone element) is configured to detect the sound introduced through a through hole 12 formed in the substrate 1. If a short circuit occurs in a portion as illustrated, the sound may be introduced through the shorted portion, as well as the through hole 12, causing noise. In the disclosure, as illustrated in FIGS. 1 to 3B and FIGS. 5A to 15B, a dummy pad (e.g., the dummy pad 114 of FIG. 2) may be provided, and a soldering material (a solder adhesive or a solder paste) may be overapplied to the connection pad 11 to prevent poor interconnection between the electronic component and the pad which can cause a short circuit.

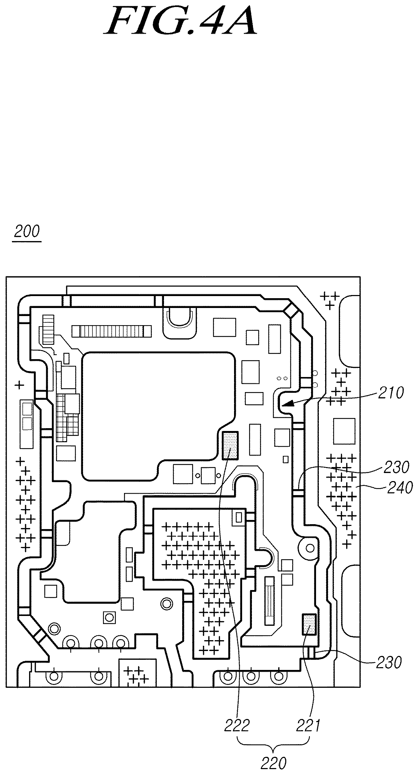

FIG. 4A is a plan view illustrating an example printed circuit board assembly according to various embodiments.

The PCB assembly 200 illustrated in FIG. 4A is an example embodiment of the PCB assembly 100 described above with reference to FIGS. 1 to 3B. The PCB assembly 200 illustrated in FIG. 4A is an example embodiment, and the scope of the disclosure is not limited by the illustrated shape and arrangement relationship.

Referring to FIG. 4A, the PCB assembly 200 may include a PCB 210, an electronic component 220, a bridge section 230, or a dummy substrate 240. The PCB 210 and the dummy substrate 240 may be connected by the bridge section 230. The PCB 210 may correspond to the PCB 110 of FIGS. 1 to 3B. The electronic component 220 may correspond to the electronic component 120 of FIGS. 1 to 3B. The bridge section 230 may correspond to the bridge section 130 of FIGS. 1 to 3B. The dummy substrate 240 may correspond to the dummy substrate 140 of FIGS. 1 to 3B. hereinafter, descriptions of duplicate configurations will be omitted.

According to an embodiment, the electronic component 220 may be mounted on the PCB 210. The electronic component 220 may include a first electronic component 221 and a second electronic component 222 disposed relatively farther away from an edge than the first electronic component 221. The first electronic component 221 may be, e.g., a microphone element.

One bridge section 230 may be provided around the first electronic component 221. The one bridge section 230 may be provided to prevent a portion of the PCB 210 from being bent or deformed in a high temperature environment in a reflow process of a manufacturing process of the PCB assembly 200. However, with only one bridge section 230, bending may persist in and/or around the edge portion which is relatively more vulnerable to bending in a high temperature environment.

The bridge section 230 may be a component which is to be cut or removed when the PCB 210 is separated from the dummy substrate 240 during the manufacturing process of the PCB assembly 200. Dust (or fine dust) may be generated when the bridge section 230 is cut or removed. A method for preventing an edge portion of the PCB 210 from being bent or deformed in a high temperature environment is to provide an additional bridge section 230 around the edge. However, if the number of bridge sections 230 increases, dust (or fine dust) may be generated during the process of cutting or removing the bridge section 230. The fine dust may be introduced to the inside of the first electronic component 221 through the penetrated portion of the PCB 210 under the first electronic component 221 (e.g., a microphone element). As a result, the defect rate may increase. Therefore, using a method other than providing an additional bridge section 230 around the first electronic component 221 may be needed to prevent solder ball from escaping or poor interconnection, which can cause a short circuit between the first electronic component 221 and the PCB 210.

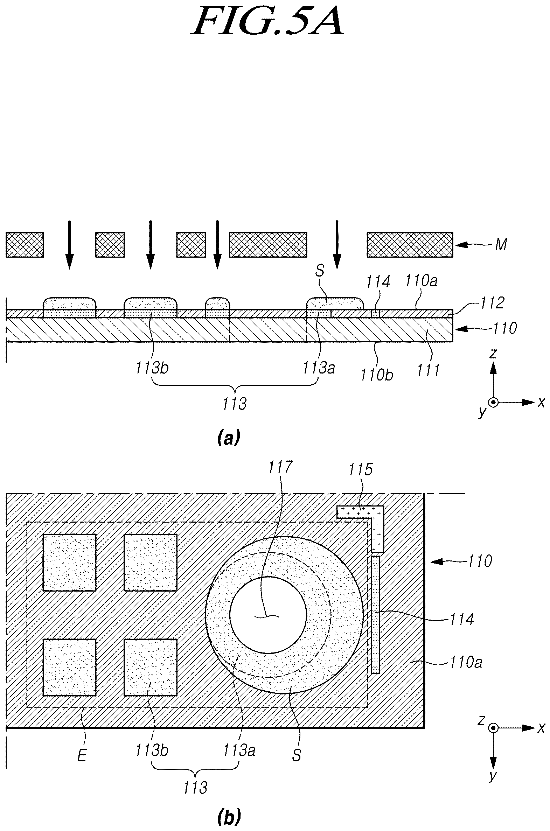

In the disclosure, the issue may be addressed by configuring a dummy pad (e.g., the dummy pad 114 of FIG. 2), as described with reference to FIGS. 1 to 3B and described below with reference to FIG. 5A, may be configured to address the issue discussed above regarding a method other than providing an additional section.

FIG. 4B is a view illustrating a first substrate mounted on an electronic device according to various embodiments.

FIG. 4B is an internal plan view illustrating a PCB 310 disposed in an electronic device 300. Here, the PCB 310 may correspond to the PCB 210 of FIG. 4A. The PCB 310 illustrated in FIG. 4B is an example embodiment, and the scope of the disclosure is not limited by the illustrated shape and arrangement relationship. The PCB 310 may have various shapes depending on the type and/or structure of the electronic device 300.

The PCB 310 may be disposed in an area defined by a first side member 301, a second side member 302 extending in a vertical direction from one end of the first side member 301, and a third side member 303 extending in a vertical direction from the other end of the first side member 301. The PCB 310 may be disposed so that the electronic component 320 (e.g., a microphone element) is positioned adjacent to one lateral side of the electronic device 300. For example, the PCB 310 may be disposed so that the electronic component 320 (e.g., a microphone element) is adjacent to the first side member 301. Accordingly, when the electronic component 320 (e.g., a microphone element) is mounted on the PCB 310, it may be mounted adjacent to or near the edge.

When a PCB assembly (e.g., the PCB assembly 100 of FIG. 1 or the PCB assembly 200 of FIG. 4A) is manufactured, the electronic component 320 (e.g., a microphone element) may be disposed adjacent to an edge, and its surroundings may become vulnerable to short-circuiting or solder ball from escaping in a reflow process. Accordingly, in the disclosure, as described with reference to FIGS. 1 to 3B and described below with reference to FIG. 5A, a dummy pad (e.g., the dummy pad 114 of FIG. 2) may be provided around the electronic component 320 to prevent short-circuiting or solder ball from escaping between the electronic component 320 and the PCB 310 due to bending.

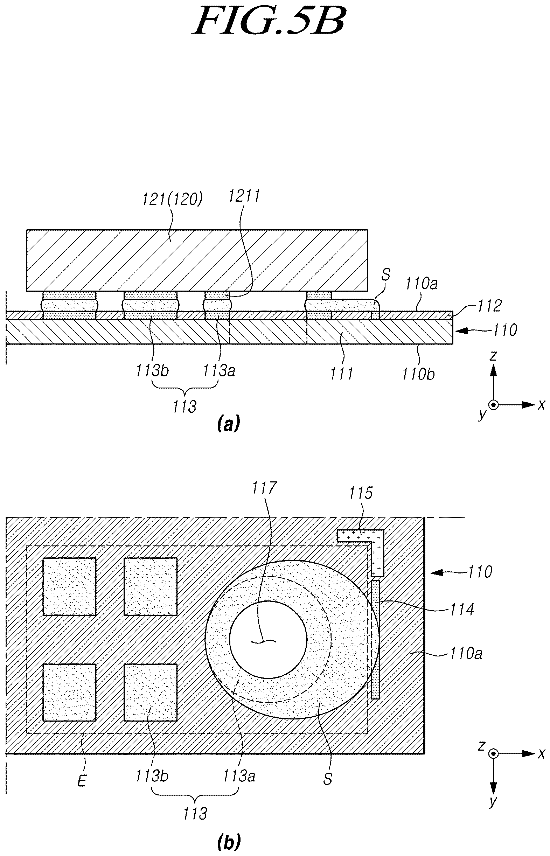

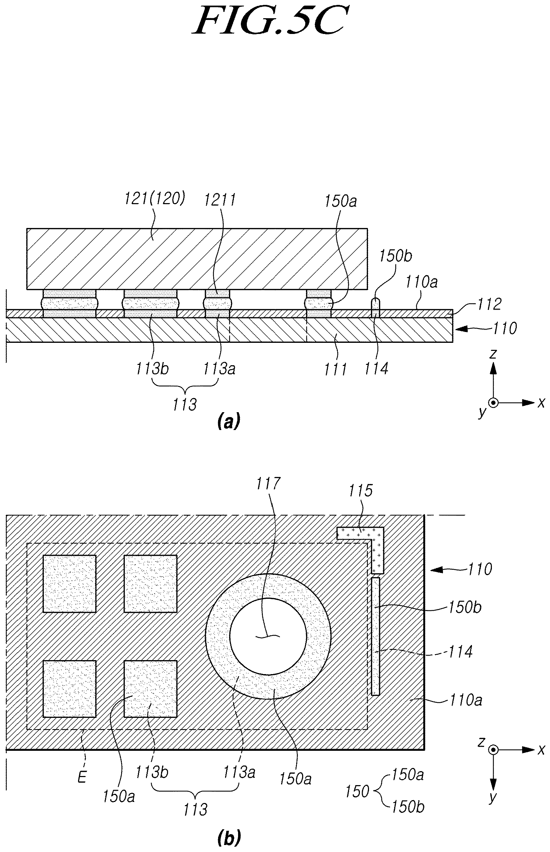

FIGS. 5A, 5B, and 5C are views illustrating example processes for manufacturing a printed circuit board assembly according to various embodiments.

The components illustrated in FIGS. 5A, 5B, and 5C may be substantially the same as or similar to the components illustrated in FIGS. 1 to 3B, and the same reference numerals are used for substantially the same or similar components. The manufacturing process of the PCB assembly illustrated in FIGS. 5A, 5B, and 5C may be applied not only to the PCB assembly 100 illustrated in FIGS. 1 to 3B but also to various embodiments to be described below. In FIGS. 5A, 5B, and 5C, some steps of the manufacturing process of the PCB assembly are described. A manufacturing process of mounting an electronic component on a substrate using the SMT process is described with reference to FIGS. 5A, 5B, and 5C. Hereinafter, a process of mounting the first electronic component 121 is described as an example, but the disclosure is not limited thereto.

In FIGS. 5A to 5C, an example of a section or part of the first connection pad 113a of the PCB 110 which is bent or deformed in the reflow process is described. This is an example embodiment, and the manufacturing process to be described below may be applied not only to the first connection pad 113a, but also to the other connection pad disposed at the portion where the PCB 110 is bent. Hereinafter, for convenience of description, a case in which only one dummy pad 114 is provided is described as an example.

Referring to FIG. 5A, the manufacturing process of the PCB assembly may include applying a solder material (S) (e.g., solder adhesive, solder paste, or solder cream) on the PCB 110. A metal mask M, having an open pattern corresponding to the pattern of the connection pad 113, may be used to apply the soldering material S on the connection pad 113. After the metal mask M is fixed on the PCB 110, for example, the soldering material S may be applied on the connection pad 113.

According to an embodiment, the metal mask M may be formed or prepared in a way that the soldering material S may be overapplied on the first connection pad 113a. A size of an opening of the metal mask M corresponding to the first connection pad 113a may be larger than the size of the first connection pad 113a. Overapplying the soldering material S may mean that an amount of excess soldering material applied is appropriate for soldering the connection pad 113 to the contact point 1211 of the electronic component 120 (e.g., the first electronic component 121). The amount of the soldering material S applied on the first connection pad 113a may be about 20% to 30% more than the amount conventionally applied. The specific gravity of the overapplied soldering material S is not limited thereto.

When the soldering material S is applied in excess (e.g., overapplied) on the connection pad 113, the excess portion or amount may be separated during the reflow process which can cause a short in neighboring or nearby elements. In various embodiments of the disclosure, a dummy pad may be provided to prevent a solder ball from escaping to the neighboring elements or a connection pad. In various embodiments of the disclosure, the solder ball escape may be prevented by having the dummy pad distribute the excess soldering material S.

The excess amount or portion of the applied soldering material S may extend or project (e.g., not contained within the surface area of the pad) from the first connection pad 113a as illustrated in FIG. 5A(b). For example, a portion of the soldering material S applied on the first connection pad 113a may overlap the first connection pad 113a, and the remaining portion may not overlap the first connection pad 113a. The soldering material S applied on the first connection pad 113a may be applied to extend or overflow toward the dummy pad 114. For example, the excess amount or portion of the applied soldering material S on the first connection pad 113a may extend or project toward the dummy pad 114 along one side (e.g., the upper side 110a) of the PCB 110. For example, the excess amount or portion of the applied soldering material S on the first connection pad 113a may extend or project in the right direction (e.g., +x-direction) as illustrated, and the direction of overflow may vary depending on the position where the dummy pad 114 is disposed. For example, when a plurality of dummy pads 114 are provided, although not illustrated, the excess amount or portion of the applied soldering material S on the first connection pad 113a may be extend or project in a plurality of directions.

When the soldering material S is applied on the first connection pad 113a, the soldering material S may be applied not to overlap the dummy pad 114 as illustrated. However, the disclosure is not limited thereto, and the soldering material S may be applied to overlap the first connection pad 113a and the dummy pad 114.

Referring to FIG. 5B, the manufacturing process of the PCB assembly may include mounting or seating the electronic component 120 (e.g., the first electronic component 121) after applying the soldering material S. For example, the electronic component 120 (e.g., the first electronic component 121) may be mounted or seated on the soldering material S applied to the connection pad 113. When the electronic component 120 (e.g., the first electronic component 121) is mounted or seated on the soldering material S, the soldering material S may be pressed and spread in a horizontal direction (e.g., a direction including the x-axis and/or the y-axis). For example, when the electronic component 120 (e.g., the first electronic component 121) is mounted on the PCB 110, the soldering material S may be spread by the load of the electronic component 120 (e.g., the first electronic component 121).

The soldering material S may be semi-liquid. The semi-liquid type may correspond to a state in which its shape may be changed by an external force. For example, it may be in a state that is intermediate between a semi-liquid solid state and a liquid state.

The excess amount or portion of the soldering material S overapplied on the first connection pad 113a may extend or project toward the dummy pad 114, so that when the electronic component 120 (e.g., the first electronic component 121) is seated, the soldering material S may horizontally spread to contact the dummy pad 114 or to cover at least a portion of the dummy pad 114. When the distance between the dummy pad 114 and the first connection pad 113a is far (or significant), the soldering material S pressed and spread by the electronic component 120 (e.g., the first electronic component 121) may not reach the dummy pad 114. Accordingly, an appropriate distance is required between the first connection pad 113a and the dummy pad 114. For example, the dummy pad 114 may be configured to be disposed within 0.01 mm from the edge virtual line E as described above. For example, the dummy pad 114 may be configured to be disposed within 0.01 mm in the horizontal direction from the edge of the electronic component 120 (e.g., the first electronic component 121).

Referring to FIG. 5C, the manufacturing process of the PCB assembly may include a reflow process for melting and reflowing the soldering material S. The reflow process may refer to a process of melting and reflowing the soldering material S by exposing the PCB assembly of FIG. 5B to a high temperature environment.

In a high temperature environment, the soldering material S may be melted to form a surface tension, and the soldering material S, positioned on the protective layer 112 on which the solder resist is formed, may be positioned on or attached to a pad (e.g., the connection pad 113 or the dummy pad 114) by the surface tension. In the reflow process, the soldering material S covering a portion of the first connection pad 113a and the dummy pad 114 is melted by high heat. At this time, as the flux component included in the soldering material S melts, the surface of the pad (e.g., the connection pad 113 or the dummy pad 114) may be coated with the flux component, forming an alloy layer. While the alloy layer is formed, gas may be generated from the soldering material S and discharged to the outside. The gas generated from the soldering material S applied to the lower side of the first electronic component 121 may be discharged to the outside, and thus at least a portion of the soldering material S overapplied on the first connection pad 113a may be moved toward the dummy pad 114. As the gap between the first electronic component 121 and the PCB 110 decreases, the soldering material S may be scattered to the outside due to the flux and gas generated when the soldering material S is melted.

The soldering material S covering the first connection pad 113a and a portion of the dummy pad 114 as the first electronic component 121 is mounted may be distributed onto each pad (e.g., the connection pad 113 or the dummy pad 114) by the surface tension formed as the soldering material S is melted in the reflow process. Since the protective layer 112 is formed of a solder resist material, the molten soldering material S is not distributed on the protective layer 112. Tension attracted by surface tension may be formed in the molten soldering material S. By the tension formed on each of the first solder ball 150a positioned on the first connection pad 113a and the second solder ball 150b positioned on the dummy pad 114, each of the first solder ball 150a and the second solder ball 150b may attract the soldering material S positioned on the protective layer 112. The first solder ball 150a and the second solder ball 150b may be disconnected from each other by tension.

The solder ball 150 may be formed on each of the first connection pad 113a and the dummy pad 114. The first solder ball 150a melted and reflowed on the connection pad 113 may electrically connect the connection pad 113 and the contact point 1211. The second solder ball 150b melted and reflowed on the dummy pad 114 may be spaced apart from the electronic component 120 (e.g., the first electronic component 121).

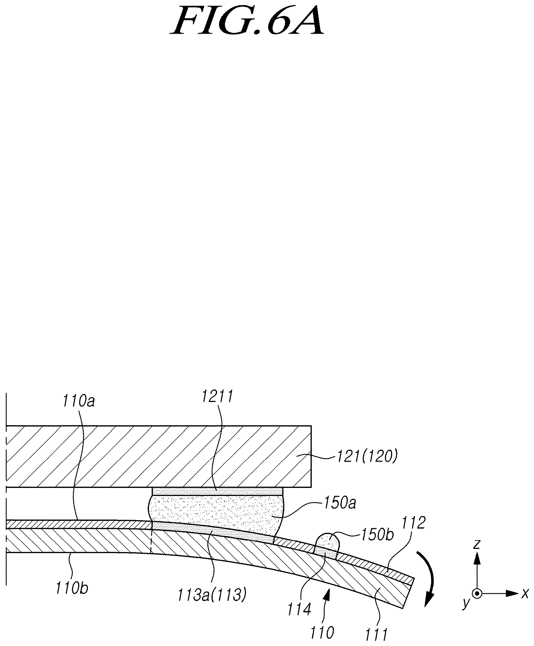

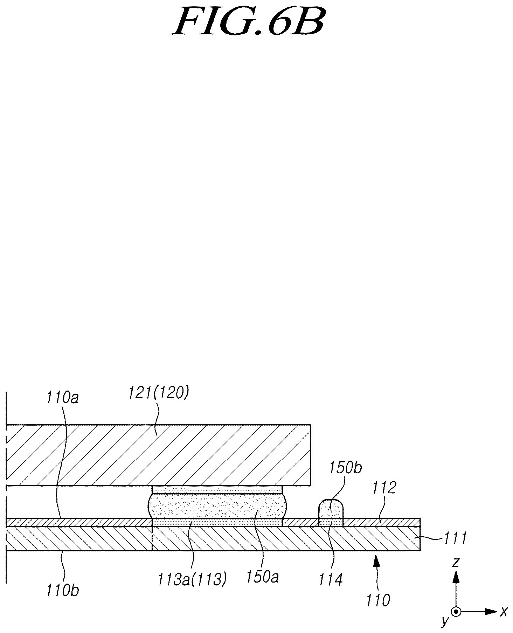

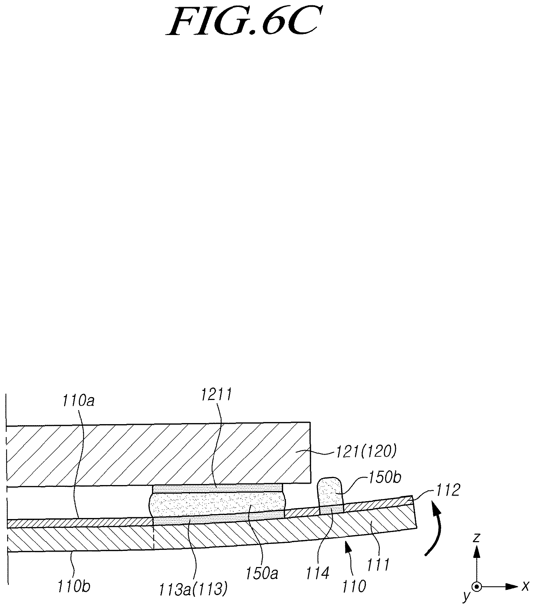

FIGS. 6A, 6B, and 6C are views illustrating occurrence of bending during a reflow process in a printed circuit board assembly according to various embodiments.

FIGS. 6A, 6B, and 6C illustrate a shape of a substrate that may occur in the reflow process of FIG. 5C.

In the reflow process, a portion of the PCB 110 may be deformed or maintained as illustrated in one of FIG. 6A, FIG. 6B, or FIG. 6C. For example, referring to FIGS. 6A and 6C, a portion of the PCB 110 may be bent or deformed in a high temperature environment of the reflow process. For example, the edge portion of the PCB 110 may be bent or deformed during the reflow process. For example, in the reflow process, a corner portion of the PCB 110 may be bent. When a portion of the PCB 110 is bent in a high heat environment, the PCB 110 may be bent in a direction away from the first electronic component 121 as illustrated in FIG. 6A. When a portion of the PCB 110 is bent in a high heat environment, the PCB 110 may be bent toward the first electronic component 121 as illustrated in FIG. 6C.

Referring to FIG. 6A, in the high temperature environment of the reflow process, bending may occur on the edge side of the PCB 110. As illustrated, a portion of the edge of the PCB 110 may be bent away from the electronic component 120 (e.g., the first electronic component 121) due to the high temperature. In this case, the distance between the contact point 1211 and the first connection pad 113a increases, and the amount or size of the first solder ball 150a required for connecting the contact point 1211 and the first connection pad 113a also increases.

In the disclosure, a sufficient amount or size of the first solder ball 150a, which may fill the space between the first connection pad 113a and the contact point 1211, may be formed even if the PCB 110 is bent by overapplying the soldering material (e.g., the soldering material S of FIG. 5A) on the first connection pad 113a. Accordingly, even when the PCB 110 is bent in the reflow process, a short circuit may be prevented between the contact point 1211 and the first connection pad 113a.

For example, if the first electronic component 121 is a microphone element, when a short circuit occurs between the contact point 1211 and the first connection pad 113a, a sound may be introduced by the short-circuited space as described above, causing noise. In the disclosure, it is possible to contribute to enhancing the sound quality of the microphone element by preventing such a short circuit. As the amount or size of the first solder ball 150a increases, the size of the second solder ball 150b may decrease.

Referring to FIG. 6B, bending may not occur despite the high temperature environment of the reflow process. In this case, the excess portion of the soldering material S overapplied on the first connection pad 113a may be moved (or applied or transferred) onto the dummy pad 114 during the melting and reflow process.

Referring to FIG. 6C, in the high temperature environment of the reflow process, bending may occur on the edge side of the PCB 110. As illustrated, a portion of the edge of the PCB 110 may be bent toward the electronic component 120 (e.g., the first electronic component 121) due to the high temperature. In this case, the distance between the contact point 1211 and the first connection pad 113a decreases, and the amount or size of the first solder ball 150a required to connect the contact point 1211 and the first connection pad 113a may also be reduced. The remaining (or excess) soldering material S, after soldering the space between the contact point 1211 and the first connection pad 113a, may be moved or applied on the dummy pad 114. The remaining soldering material S, after soldering the space between the contact point 1211 and the first connection pad 113a, may be attracted by the tension of the molten soldering material S positioned on the dummy pad 114. In the disclosure, even when the PCB 110 is bent toward the electronic component 120 (e.g., the first electronic component 121), the dummy pad 114 may prevent the solder ball from escaping, thereby preventing a short circuit from occurring.

Even when the PCB 110 is bent toward the electronic component 120 (e.g., the first electronic component 121) in the reflow process, the excess portion of the overapplied soldering material S may be moved (or applied or transferred) onto the dummy pad 114.

Accordingly, even when the soldering material S is overapplied during the reflow process, the dummy pad 114 may limit the movement of the excess soldering material S, thereby preventing the excess soldering material S from being moved (or applied) to effect nearby electronic components and/or connection pads.

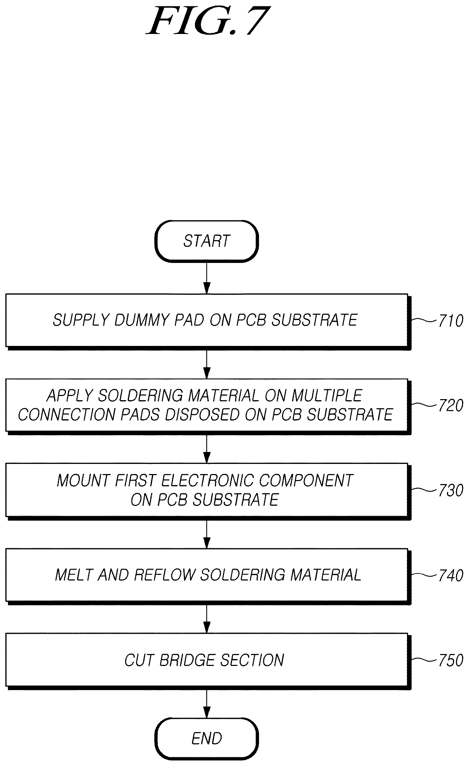

FIG. 7 is a flowchart illustrating an example method for manufacturing a printed circuit board assembly according to various embodiments.

Hereinafter, a method for manufacturing a PCB assembly is described by exemplifying the PCB assembly 100 illustrated in FIGS. 1 to 6C. The manufacturing method described below may also be applied to embodiments described below. The flowchart of FIG. 7 illustrates a part of the manufacturing process of the PCB assembly.

Referring to FIG. 7, the method for manufacturing the PCB assembly 100 may include the step 710 of supplying or disposing the dummy pad 114 on the PCB 110. The dummy pad 114 may be mounted on the PCB 110. Here, the PCB 110 may be supported by the dummy substrate 140 through the plurality of bridge sections 130. For example, the PCB 110 may be connected to and supported on the dummy substrate 140 by the bridge section 130. The PCB 110 may include a plurality of connection pads 113.

The method for manufacturing the PCB assembly 100 may include the step 720 of applying the soldering material S to the plurality of connection pads 113 disposed on the PCB 110. For the first connection pad 113a, among the plurality of connection pads 113, the soldering material S may be applied to extend (or project) toward the dummy pad 114 disposed around the first connection pad 113a. Step 720 may correspond to the manufacturing process of FIG. 5A.

The method for manufacturing the PCB assembly 100 may include the step 730 of mounting the first electronic component 121 on the PCB 110 (or the first connection pad 113a). When the first electronic component 121 is mounted, the first electronic component 121 may press the soldering material S to spread (or extend) in the horizontal direction. In this case, the first electronic component 121 may be mounted while pressing the soldering material S so that the soldering material S applied on the first connection pad 113a may be positioned or attached to at least a portion of the dummy pad 114. In response to mounting of the first electronic component 121 on the first connection pad 113a, the soldering material S applied on the first connection pad 113a may contact a portion of the dummy pad 114. Step 730 may correspond to the manufacturing process of FIG. 5B.

The method for manufacturing the PCB assembly 100 may include the step 740 of melting and reflowing the soldering material S positioned between the first electronic component 121 and the PCB 110 (or the first connection pad 113a). In the process of melting the soldering material S, surface tension of the soldering material S is increased so that the soldering materials S, positioned on the protective layer 112, may be gathered on a pad (e.g., the connection pad 113 or the dummy pad 114). When the soldering material S is melted, an appropriate distance (e.g., a certain distance) between the first electronic component 121 and the PCB 110 may be maintained by supporting as the weight of the first electronic component 121 is supported by the tension of the melted soldering material S. The soldering material S may be reflowed to form the first solder ball 150a on the connection pad 113 and the second solder ball 150b on the dummy pad 114. Step 740 may correspond to the manufacturing process of FIG. 5C.

The method for manufacturing the PCB assembly 100 may include the step 750 of cutting (or severing) the bridge section 130. When the bridge section 130 is cut, the PCB 110 may be separated from the dummy substrate 140.

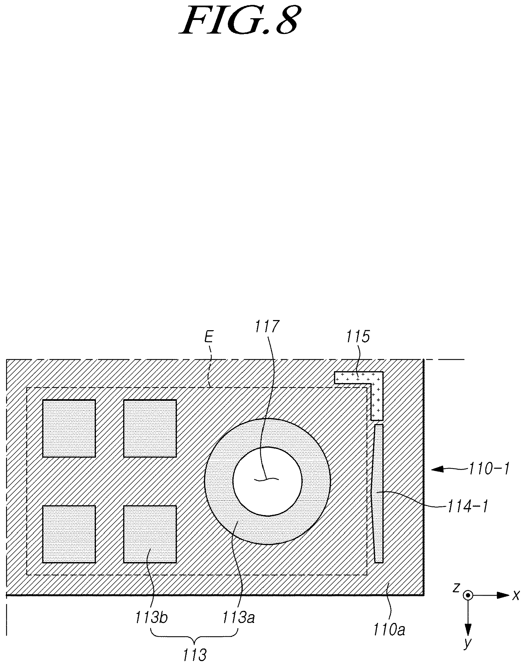

FIG. 8 is a plan view illustrating an example substrate according to various embodiments.

A PCB 110-1 illustrated in FIG. 8 may be included in the PCB assembly 100 of FIG. 1. In the PCB 110-1 illustrated in FIG. 8, the same reference numerals are assigned to components that are substantially the same as or similar to the PCB 110 illustrated in FIGS. 1 to 3B.

Referring to FIG. 8, the PCB 110-1 may include a dummy pad 114-1. The dummy pad 114-1 may be disposed on the outside of the structural boundary of the electronic component 120. For example, the dummy pad 114-1 may be disposed on the outside of the structural boundary of the first electronic component 121. The dummy pad 114-1 may be disposed around or near an electronic component (e.g., the first electronic component 121) disposed adjacent to a corner of the PCB 110-1. The dummy pad 114-1 may be disposed to be visible on the outside of the structural boundary of the electronic component 120 when viewed in a downward direction (e.g., -z-direction or from the top). The dummy pad 114-1 may be disposed between the outside boundary of the electronic component 121 and the edge or corner of the substrate.

The dummy pad 114-1 may be disposed adjacent to one connection pad (e.g., the first connection pad 113a) among the plurality of connection pads 113. For example, the one connection pad (e.g., the first connection pad 113a) may refer to a connection pad in which bending (or deformation) of the PCB 110-1 occurs in a reflow process which can cause a short circuit to occur.

The dummy pad 114-1 may be configured to extend in a direction parallel to one of the edges of the first electronic component 121. The dummy pad 114-1 may have a shape in which one side extends in a certain direction (e.g., projects or elongated). For example, the dummy pad 114-1 may be formed so that a portion thereof extends or projects toward the first electronic component 121. For example, the dummy pad 114-1 may be configured so that a portion thereof extends toward the edge virtual line E. For example, the dummy pad 114-1 may be configured to extend toward the first connection pad 113a.

The dummy pad 114-1 may be disposed on the outside of the edge virtual line E. For example, the dummy pad 114-1 may be disposed to be spaced apart from the edge virtual line E by a predetermined interval(or width). For example, the dummy pad 114-1 may be disposed to be spaced apart from the edge virtual line E by 0.01 mm or less. The distance between the dummy pad 114-1 and the edge virtual line E may be up to 0.01 mm. For example, the dummy pad 114-1 may be disposed to be spaced 0.01 mm or less horizontally apart from the corner of the first electronic component 121. However, the disclosure is not limited thereto, and the dummy pad 114-1 may be disposed inside the edge virtual line E. According to an example, the protrusion protruding or extending from the dummy pad 114-1 toward the first connection pad 113a may be disposed to overlap or span the edge virtual line E, although not illustrated.

The dummy pad 114-1 may be disposed not to overlap the first electronic component (e.g., the electronic component 121 of FIG. 3B). For example, the dummy pad 114-1 may be disposed not to overlap or span the corner of the first electronic component 121. The corner of the first electronic component 121 may include, e.g., a corner in three dimensions. The three-dimensional corner may be provided, e.g., as the front side contacts the lateral sides. For example, the dummy pad 114-1 may be disposed not to overlap or span the edge virtual line E. According to an example, although not illustrated, the dummy pad 114-1 may be disposed so that a portion of the protrusion protruding (or extending) toward the first connection pad 113a overlaps the first electronic component 121.

The surface of the dummy pad 114-1 may be soldered. The dummy pad 114-1 may be electrically separated or independent from the connection pad 113 or the contact point 1211 but may be soldered in the manufacturing process.

The dummy pad 114-1 may be configured to be electrically separated (or independent) from the connection pad 113. The dummy pad 114-1 may be configured to be electrically separated from an electronic component (e.g., the first electronic component 121 of FIG. 3B). For example, circuit lines for electrical connection may be omitted from the dummy pad 114-1.

An area of the dummy pad 114-1 may be smaller than an area of one adjacent connection pad (e.g., the first connection pad 113a). For example, the area of the dummy pad 114-1 may be 30% or less than the area of one adjacent connection pad (e.g., the first connection pad 113a). For example, the area of the dummy pad 114-1 may be 10% or more than the area of one adjacent connection pad (e.g., the first connection pad 113a). Accordingly, a size of the solder ball (e.g., the first solder ball 150a of FIG. 3B) provided on one connection pad (e.g., the first connection pad 113a) may be larger than a size of the solder ball provided on the dummy pad 114-1.

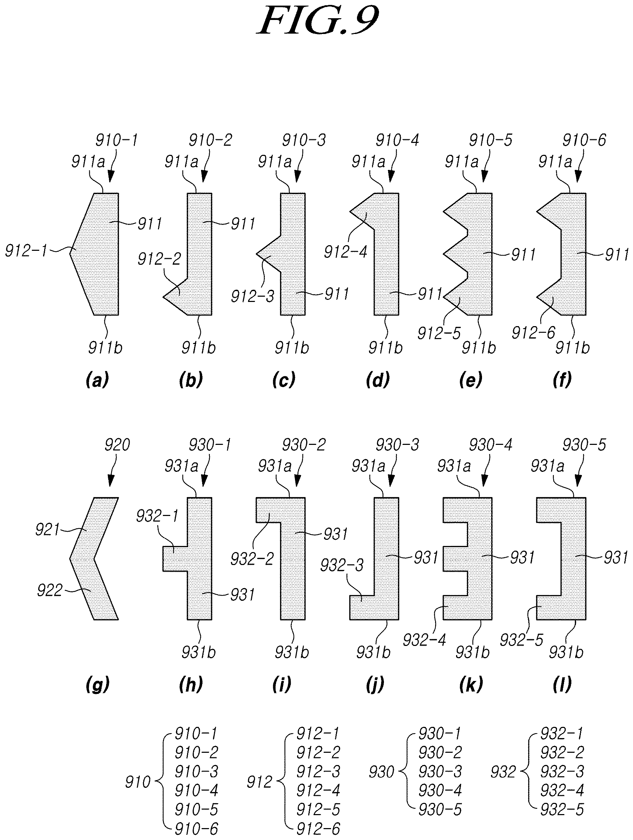

FIG. 9 is a view illustrating various shapes of a dummy pad in a printed circuit board assembly according to various embodiments.

Dummy pads 910, 920, and 930 of various shapes illustrated in FIG. 9 are exemplary, and the illustrated shapes do not limit the scope of the disclosure. At least one of the dummy pads 910, 920, and 930 of various shapes illustrated in FIG. 9 may replace the dummy pad 114-1 of the PCB 110-1 of FIG. 8. At least one of the dummy pads 910, 920, and 930 of various shapes illustrated in FIG. 9 may be included in the PCB 110-1 of FIG. 8.

According to an embodiment, the dummy pads 910, 920, and 930 of various shapes illustrated in FIG. 9 may have shapes protruding to one side. The protrusions of the dummy pads 910, 920, and 930 may protrude or extend, e.g., toward a first connection pad (e.g., the connection pad 113a of FIG. 8) as described with reference to FIG. 8.

The dummy pads 910 illustrated in (a) to (f) of FIG. 9 may include a body portion 911 and a protrusion 912. The body portion 911 may refer to a pad substantially rectangular in shape, extending to one side. The body portion 911 may include a first end portion 911a and a second end portion 911b, which are opposite end portions in the length direction. The protrusion 912 may extend or protrude toward the first connection pad 113a. The protrusion 912 may extend or protrude toward the first electronic component (e.g., the electronic component 121 of FIG. 3B). The protrusion 912 may extend from the body 911 along a surface of a PCB (e.g., the PCB 110-1 of FIG. 8). The protrusion 912 may be, e.g., triangular. For example, the protrusion 912 may have a shape in which the width decreases as the distance from the body portion 911 increases. The body portion 911 and the protrusion 912 may be integrally formed with each other.

The dummy pad 910-1 illustrated in (a) of FIG. 9 may have a shape substantially the same as or similar to that of the dummy pad 114-1 of FIG. 8.

In (b) of FIG. 9, the protrusion 912-2 may extend from a portion adjacent to the second end portion 911b of the body portion 911. In (c) of FIG. 9, the protrusion 912-3 may extend from a portion adjacent to the central portion of the body portion 911. In (d) of FIG. 9, the protrusion 912-3 may extend from a portion adjacent to the first end portion 911a of the body portion 911. The position of the protrusion may vary depending on, e.g., the position of the first connection pad 113a.

In (e) of FIG. 9 and (f) of FIG. 9, a plurality of protrusions 912-5 and 912-6 may be provided. As illustrated in (e) of FIG. 9, the plurality of protrusions 912-5 may be disposed adjacent to each other. As illustrated in (f) of FIG. 9, the plurality of protrusions 912-6 may be disposed to be spaced apart from each other by a predetermined distance. As illustrated in (f) of FIG. 9, the plurality of protrusions 912-6 may be positioned adjacent to the first end portion 911a or the second end portion 911b, respectively.

The dummy pad 920 illustrated in (g) of FIG. 9 may include a first pad 921 and a second pad 922. The respective end portions of the first pad 921 and the second pad 922 may be coupled to each other to form a substantially 'V' shape. The dummy pad 920 may be disposed so that a portion, where the first pad 921 and the second pad 922 are coupled or in contact with each other, protrudes toward a first connection pad (e.g., the first connection pad 113a of FIG. 8). The first pad 921 and the second pad 922 may be integrally formed.

Dummy pads 930 illustrated in (h) to (l) of FIG. 9 may include a body portion 931 and a protrusion 932. The body portion 931 may refer to a substantially rectangular pad extending to one side. The body portion 931 may include a first end portion 931a and a second end portion 931b, which are opposite end portions in the length direction. The protrusion 932 may extend or protrude toward the first connection pad 113a. The protrusion 932 may extend or protrude toward the first electronic component (e.g., the electronic component 121 of FIG. 3B). The protrusion 932 may extend from the body 931 along a surface of a PCB (e.g., the PCB 110-1 of FIG. 8). The protrusion 932 may be, e.g., rectangular. The protrusion 932 may have, e.g., a shape extending from the body portion 931 while maintaining a width. The body portion 931 and the protrusion 932 may be integrally formed with each other.

In (h) of FIG. 9, the protrusion 932-1 may extend from a portion adjacent to the central portion of the body portion 931. In (i) of FIG. 9, the protrusion 932-2 may extend from a portion adj acent to the first end portion 931a of the body portion 931. In (j) of FIG. 9, the protrusion 932-3 may extend from a portion adjacent to the second end portion 931b of the body portion 931. The position of the protrusion may vary depending on, e.g., the position of the first connection pad 113a.

In (k) of FIG. 9 and (l) of FIG. 9, a plurality of protrusions 932-4 and 932-5 may be provided. As illustrated in (k) of FIG. 9, a plurality of protrusions 932-4 may be disposed adjacent to each other. As illustrated in (l) of FIG. 9, the plurality of protrusions 932-5 may be disposed to be spaced apart from each other by a predetermined distance. As illustrated in (l) of FIG. 9, the plurality of protrusions 932-5 may be positioned adjacent to the first end 931a or the second end 931b, respectively.

Although not illustrated, the protrusion may have a semi-circular shape and may have other various shapes.

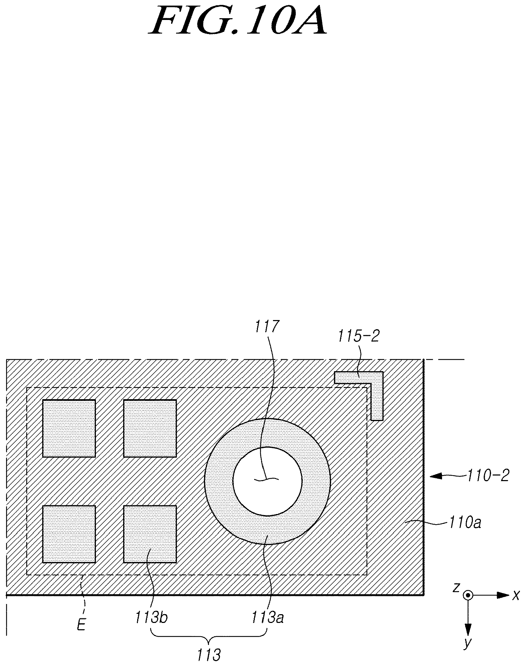

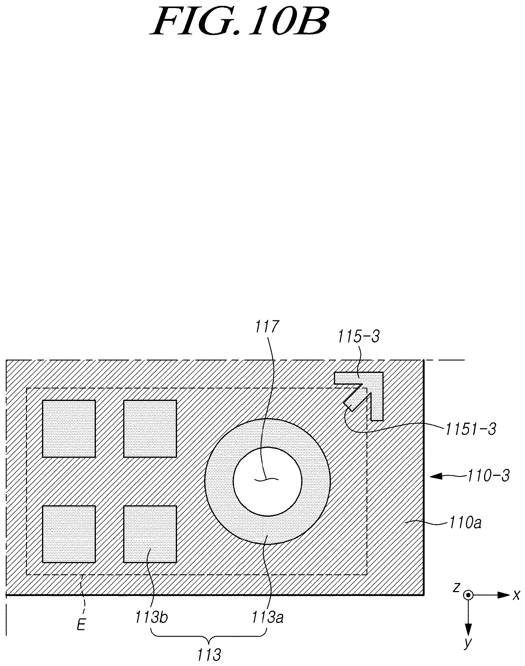

FIGS. 10A and 10B are plan views illustrating an example substrate according to various embodiments.

PCBs 110-2 and 110-3 illustrated in FIGS. 10A and 10B may be included in the PCB assembly 100 of FIG. 1. In the PCBs 110-2 and 110-3 illustrated in FIGS. 10A and 10B, the same reference numerals are assigned to components that are substantially the same as or similar to the PCB 110 illustrated in FIGS. 1 to 3B.

Referring to FIGS. 10A and 10B, the PCB 110-2 or 110-3 may include a dummy pad 115-2 or 115-3. The dummy pad 115-2 or 115-3 may be disposed outside an electronic component (e.g., the electronic component 120 of FIG. 3B). For example, the dummy pad 115-2 or 115-3 may be disposed outside the first electronic component (e.g., the first electronic component 121 of FIG. 3B). The dummy pad 115-2 or 115-3 may be disposed adjacent to a corner portion of the edge virtual line E. As described above, the dummy pad 115-2 or 115-3 may serve to distribute the soldering material S overapplied to the first connection pad 113a, and at the same time, may serve to guide a position where an electronic component (e.g., the electronic component 120 of FIG. 1) is mounted.

The dummy pad 115-2 or 115-3 may be disposed around an electronic component (e.g., the first electronic component 121) disposed adjacent to the edges of the PCB 110-2 or 110-3. The dummy pad 115-2 or 115-3 may be disposed to be visible to the outside of the electronic component 120 when viewed in the direction from the upper side to the lower side (e.g., the -z-direction).

The dummy pad 115-2 or 115-3 may be disposed adjacent to one connection pad (e.g., the first connection pad 113a) among the plurality of connection pads 113. For example, the one connection pad (e.g., the first connection pad 113a) may refer to a connection pad in which bending of the PCB 110-2 or 110-3 may occur in the reflow process, which can cause a short circuit.

A surface of the dummy pad 115-2 or 115-3 may be soldered. The dummy pad 115-2 or 115-3 may be electrically separated from the connection pad 113 or the contact point (e.g., the contact point 1211 of FIG. 3B), but may be soldered in the manufacturing process.

The dummy pad 115-2 or 115-3 may be configured to be electrically separated from the connection pad 113. The dummy pad 115-2 or 115-3 may be configured to be electrically separated from an electronic component (e.g., the first electronic component 121). For example, circuit lines for electrical connection may be omitted from the dummy pad 115-2 or 115-3.

An area of the dummy pad 115-2 or 115-3 may be smaller than an area of one adjacent connection pad (e.g., the first connection pad 113a). For example, the area of the dummy pad 115-2 or 115-3 may be 30% or less than the area of one adjacent connection pad (e.g., the first connection pad 113a). For example, the area of the dummy pad 115-2 or 115-3 may be 10% or more than the area of one adjacent connection pad (e.g., the first connection pad 113a). Accordingly, a size of the solder ball (e.g., the first solder ball 150a of FIG. 3B) provided on one connection pad (e.g., the first connection pad 113a) may be larger than a size of the solder ball provided on the dummy pad 115-2 or 115-3.

Referring to FIG. 10A, the dummy pad 115-2 may be disposed outside the edge virtual line E. For example, the dummy pad 115-2 may be disposed to be spaced apart from the edge virtual line E by a predetermined interval or distance. For example, the dummy pad 115-2 may include two elongated portions. The two elongated portions may be coupled to be disposed adjacent to a corner of the electronic component 121.

The respective end portions of the two elongated portions of the dummy pad 115-2 may be connected to form a substantially right angle. The dummy pad 115-2 may have an "¬" shape. However, the disclosure is not limited thereto, and two elongated portions of the dummy pad 115-2 may be coupled to form an angle corresponding to the angle of the corner portion of the electronic component 121.

For example, the dummy pad 115-2 may be disposed to be spaced apart from the edge virtual line E by 0.01 mm or less. The distance between the dummy pad 115-2 and the edge virtual line E may be up to 0.01 mm. For example, the dummy pad 115-2 may be disposed to be spaced apart from the edge of the electronic component (e.g., the first electronic component 121) by 0.01 mm or less outward in the horizontal direction.

The dummy pad 115-2 may be disposed not to overlap the first electronic component 121. For example, the dummy pad 115-2 may be disposed not to overlap or span the corner of the first electronic component 121. For example, the dummy pad 115-2 may be disposed not to overlap or cover the edge virtual line E. According to an example, although not illustrated, the dummy pad 115-2 may be disposed so that a portion of the protrusion extending or projecting toward the first connection pad 113a overlaps the first electronic component 121.

Referring to FIG. 10B, different from the dummy pad 115-2 of FIG. 10A, the dummy pad 115-3 may include a protrusion 1151-3 having one side protruding or extending. For example, the dummy pad 115-3 may be formed so that a portion thereof protrudes or extends toward a first electronic component (e.g., the first electronic component 121 of FIG. 3B). For example, the dummy pad 115-3 may be formed so that a portion thereof protrudes or extends toward the first connection pad 113a. For example, the dummy pad 115-3 may be configured so that the protrusion 1151-3 protrudes toward the edge virtual line E. The protrusion 1151-3 of the dummy pad 115-3 may be positioned to overlap or cover the edge virtual line E. A portion of the protrusion 1151-3 of the dummy pad 115-3 may protrude or extend inward of the edge virtual line E. A portion of the protrusion 1151-3 of the dummy pad 115-3 may be positioned to overlap the first electronic component 121.

Due to the shape of the protrusion 1151-3, the distance between the first connection pad 113a and the dummy pad 115-3 is reduced, and as a result, a soldering material (e.g., the soldering material S of FIG. 5A) overapplied on the first connection pad 113a may be more easily distributed to the dummy pad 115-3.

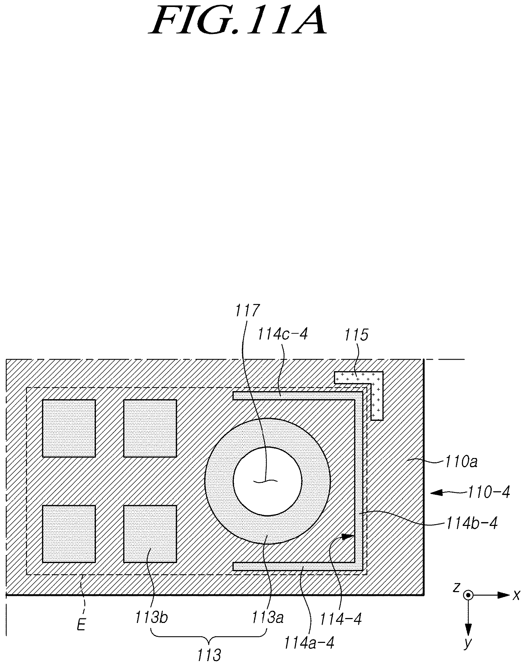

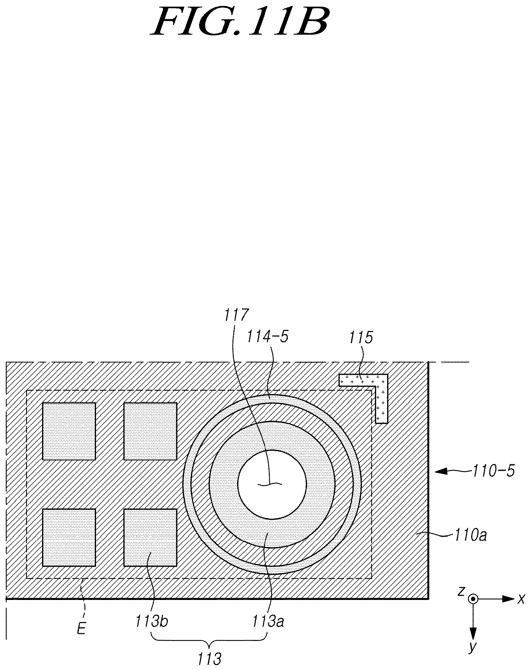

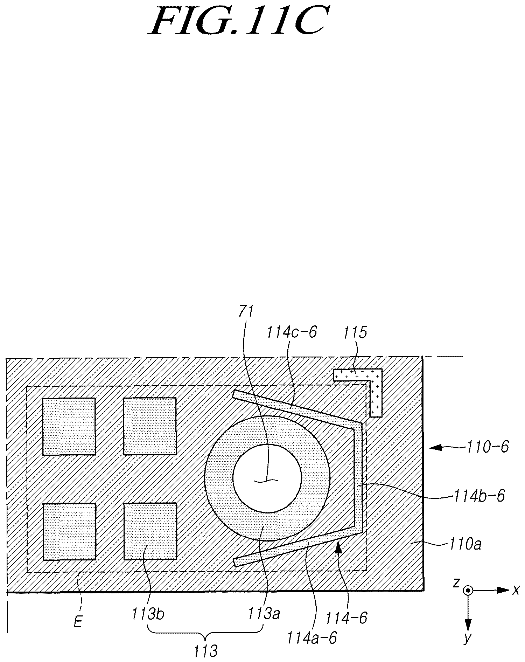

FIGS. 11A, 11B, and 11C are plan views illustrating an example substrate according to various embodiments.

APCB 110-4, 110-5, or 110-6 illustrated in FIG. 11A, 11B, or 11C may be included in the PCB assembly 100 of FIG. 1. In the PCB 110-4, 110-5, or 110-6 illustrated in FIG. 11A, 11B, or 11C, the same reference numerals are assigned to components that are substantially the same as or similar to the PCB 110 illustrated in FIGS. 1 to 3B.

Referring to FIG. 11A, 11B, or 11C, the PCB 110-4, 110-5, or 110-6 may include a dummy pad 114-4, 114-5, or 114-6. The dummy pad 114-4, 114-5, or 114-6 may be disposed inside an electronic component (e.g., the electronic component 120 of FIG. 3B). For example, the dummy pad 114-4, 114-5, or 114-6 may be disposed inside a first electronic component (e.g., the first electronic component 121 of FIG. 3B). The dummy pad 114-4, 114-5, or 114-6 may be disposed adjacent to the edge virtual line E. The dummy pad 114-4, 114-5, or 114-6 may be disposed inside the edge virtual line E. The dummy pad 114-4, 114-5, or 114-6 may serve to distribute the soldering material S overapplied on the first connection pad 113a as described above.

The dummy pad 114-4, 114-5, or 114-6 may be disposed below an electronic component (e.g., the first electronic component 121) disposed adjacent to an edge of the PCB 110-4, 110-5, or 110-6. The dummy pad 114-4, 114-5, or 114-6 may be disposed not to be visible when viewed in a downward direction (e.g., -z-direction or from the top).

The dummy pad 114-4, 114-5, or 114-6 may be disposed adjacent to one connection pad (e.g., the first connection pad 113a) among the plurality of connection pads 113. For example, the one connection pad (e.g., the first connection pad 113a) may refer to a connection pad in which bending or deformation of the PCB 110-4, 110-5, or 110-6 may occur in a reflow process which can cause a short circuit to occur.

A surface of the dummy pad 114-4, 114-5, or 114-6 may be soldered. The dummy pad 114-4, 114-5, or 114-6 are electrically separated from the connection pad 113 or the contact point (e.g., the contact point 1211 of FIG. 3B), but may be soldered in the manufacturing process.

The dummy pad 114-4, 114-5, or 114-6 may be configured to be electrically separated from the connection pad 113. The dummy pad 114-4, 114-5, or 114-6 may be configured to be electrically separated from an electronic component (e.g., the first electronic component 121). For example, circuit lines for electrical connection may be omitted from the dummy pad 114-4, 114-5, or 114-6.

An area of the dummy pad 114-4, 114-5, or 114-6 may be smaller than an area of one adjacent connection pad (e.g., the first connection pad 113a). For example, the area of the dummy pad 114-4, 114-5, or 114-6 may be 30% or less than the area of one adjacent connection pad (e.g., the first connection pad 113a), but is not limited thereto. For example, the area of the dummy pad 114-4, 114-5, or 114-6 may be 10% or more than the area of one adjacent connection pad (e.g., the first connection pad 113a), but is not limited thereto. Accordingly, a size of the solder ball (e.g., the first solder ball 150a of FIG. 3B) provided on one connection pad (e.g., the first connection pad 113a) may be larger than a size of the solder ball provided on the dummy pad 114-4, 114-5, or 114-6.

Referring to FIG. 11A, the dummy pad 114-4 may include at least one of a first pad 114a-4, a second pad 114b-4, or a third pad 114c-4. The second pad 114b-4 may extend from an end portion of the first pad 114a-4 in a direction perpendicular to the first pad 114a-4. The third pad 114c-4 may extend from an end portion of the second pad 114b-4 in a direction perpendicular to the second pad 114b-4. The first pad 114a-4 and the third pad 114c-4 may extend parallel to each other.

The dummy pad 114-4 may be disposed around the first connection pad 113a. The first pad 114a-4 may be disposed in a first direction (lower direction or +y-direction) with respect to the first connection pad 113a. The second pad 114b-4 may be disposed in a second direction (right direction or +x-direction) perpendicular to the first direction with respect to the first connection pad 113a. The third pad 114c-4 may be disposed in a third direction (upward or -y-direction) opposite to the first direction with respect to the first connection pad 113a.

The first pad 114a-4, the second pad 114b-4, and the third pad 114c-4 may be integrally formed as illustrated but are not limited thereto. Although not illustrated, the first pad 114a-4, the second pad 114b-4, and the third pad 114c-4 may be disposed to be spaced apart from each other.

A width or thickness of the dummy pad 114-4 may be 0.1 mm to 0.9 mm, but is not limited thereto. For example, a width or thickness of the first pad 114a-4 may be 0.1 mm to 0.9 mm. For example, a thickness of the second pad 114b-4 may be 0.1 mm to 0.9 mm. For example, a thickness of the third pad 114c-4 may be 0.1 mm to 0.9 mm. The respective thicknesses of the first pad 114a-4, the second pad 114b-4, and the third pad 114c-4 may be the same as or different from each other. A length of the first pad 114a-4, the second pad 114b-4, or the third pad 114c-4 may correspond to 5% to 100% of a length of the lateral side of the first electronic component 121 extending substantially parallel to the dummy pad 114. For example, the dummy pad 114-4 may have a length of 15% to 35% of the length of the lateral side of the first electronic component 121. For example, the dummy pad 114-4 may have a length of 25% to 60% of the length of the lateral side of the first electronic component 121.

For example, each of the first pad 114a-4, the second pad 114b-4, or the third pad 114c-4 may have a substantially rectangular shape extending in a direction substantially parallel to the length direction of one lateral side of the first electronic component 121.

Each of the first pad 114a-4, the second pad 114b-4, or the third pad 114c-4 may be disposed to be spaced apart from the adjacent edge virtual line E within 0.01 mm, for example. However, the disclosure is not limited thereto, and each of the first pad 114a-4, the second pad 114b-4, or the third pad 114c-4 may be disposed to be spaced apart from the adjacent edge virtual line E by 0.01 mm to 0.04 mm, for example.

Referring to FIG. 11B, the dummy pad 114-5 may be disposed to surround the first connection pad 113a. The dummy pad 114-5 may be spaced apart from the first connection pad 113a. The dummy pad 114-5 may have a circumferential shape as shown but is not limited thereto.

Referring to FIG. 11C, the dummy pad 114-6 may include at least one of a first pad 114a-6, a second pad 114b-6, or a third pad 114c-6. The second pad 114b-6 may extend from an end portion of the first pad 114a-6. The third pad 114c-6 may extend from an end portion of the second pad 114b-6. For example, the first pad 114a-6 and the second pad 114b-6 may extend to form an obtuse angle. For example, the second pad 114b-6 and the third pad 114c-6 may extend to form an obtuse angle.

The dummy pad 114-6 may be disposed around the first connection pad 113a. The first pad 114a-6 may be disposed in a first direction (lower direction or +y-direction) with respect to the first connection pad 113a. The second pad 114b-6 may be disposed in a second direction (right direction or +x-direction) perpendicular to the first direction with respect to the first connection pad 113a. The third pad 114c-6 may be disposed in a third direction (upward or -y-direction) opposite to the first direction with respect to the first connection pad 113a.

The first pad 114a-6, the second pad 114b-6, and the third pad 114c-6 may be integrally formed as illustrated but are not limited thereto. Although not illustrated, the first pad 114a-6, the second pad 114b-6, and the third pad 114c-6 may be disposed to be spaced apart from each other.

A width or thickness of the dummy pad 114-6 may be 0.1 mm to 0.9 mm but is not limited thereto. For example, a width or thickness of the first pad 114a-6 may be 0.1 mm to 0.9 mm. For example, a thickness of the second pad 114b-6 may be 0.1 mm to 0.9 mm. For example, a thickness of the third pad 114c-6 may be 0.1 mm to 0.9 mm. The respective thicknesses of the first pad 114a-6, the second pad 114b-6, and the third pad 114c-6 may be the same as or different from each other. A length of the second pad 114b-6 may have a length corresponding to 5% to 100% of the length of the lateral side of the first electronic component 121 extending substantially parallel to the dummy pad 114. For example, the second pad 114b-6 may have a length of 15% to 35% of the length of the lateral side of the first electronic component 121. For example, the second pad 114b-6 may have a length of 25% to 60% of the length of the lateral side of the first electronic component 121.

For example, each of the first pad 114a-6, the second pad 114b-6, or the third pad 114c-6 may have a substantially rectangular shape, similar to the shape of the first electronic component 121. For example, the second pad 114b-6 may extend in a direction substantially parallel to the length direction of one lateral side of the first electronic component 121.

As described above with reference to FIGS. 11A, 11B, and 11C, when the dummy pads 114-4, 114-5, and 114-6 are disposed inside the edge virtual line E, it may be advantageous for high-density mounting in component mounting design.

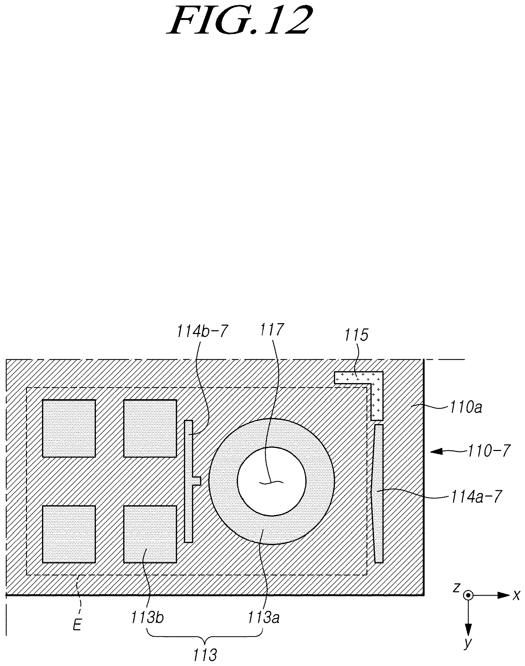

FIG. 12 is a plan view illustrating an example substrate according to various embodiments.

A PCB 110-7 illustrated in FIG. 12 may be included in the PCB assembly 100 of FIG. 1. In the PCB 110-7 illustrated in FIG. 12, the same reference numerals are assigned to components that are substantially the same as or similar to the PCB 110 illustrated in FIGS. 1 to 3B.

Referring to FIG. 12, the PCB 110-7 may include a first dummy pad 114a-7 and a second dummy pad 114b-7.

The first dummy pad 114a-7 may be disposed outside the edge virtual line E. The first dummy pad 114a-7 may be disposed to be spaced apart from the edge virtual line E. The first dummy pad 114a-7 may be formed with a protrusion extending toward the first connection pad 113a but is not limited thereto. The first dummy pad 114a-7 may have one of the shapes of the various dummy pads 910, 920, and 930 illustrated in FIG. 9.

The second dummy pad 114b-7 may be disposed inside the edge virtual line E. The second dummy pad 114b-7 may be disposed adjacent to or near the first connection pad 113a inside the edge virtual line E. The second dummy pad 114b-7 may be disposed between the first connection pad 113a and another connection pad (e.g., the second connection pad 113b) adjacent to the first connection pad 113a. The second dummy pad 114b-7 may prevent the molten solder ball on the first connection pad 113a from escaping to another adjacent connection pad (e.g., the second connection pad 113a) in the reflow process of melting and reflowing the soldering material (e.g., the soldering material S of FIG. 5A). The second dummy pad 114b-7 may form a protrusion protruding or extending toward the first connection pad 113a.

The second dummy pad 114b-7 may be disposed to overlap a first electronic component (e.g., the first electronic component 121 of FIG. 3B). The second dummy pad 114b-7 may be disposed not to be visible when viewed in the downward direction from the upper side (e.g., in the -z-direction or from the top).

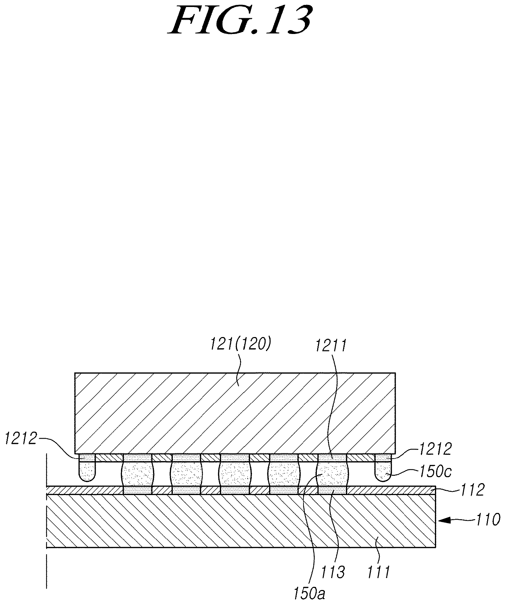

FIG. 13 is a side view illustrating an example printed circuit board assembly according to various embodiments.

The PCB 110 or the electronic component 120 illustrated in FIG. 13 may be included in the PCB assembly 100 of FIG. 1. In the PCB 110 illustrated in FIG. 13, the same reference numerals are assigned to components that are substantially the same as or similar to the PCB 110 illustrated in FIGS. 1 to 3B.

Referring to FIG. 13, the electronic component 120 (e.g., the first electronic component 121) may further include an element dummy pad 1212. The element dummy pad 1212 may have the same function as the dummy pad (e.g., the dummy pad 114 of FIG. 3B) described with reference to FIGS. 1 to 5C. The element dummy pad 1212 may be disposed outside the contact point 1211. The element dummy pad 1212 may be disposed below the electronic component 120 (e.g., the first electronic component 121). The element dummy pad 1212 may be disposed adjacent to an edge of the electronic component 120 (e.g., the first electronic component 121). As the element dummy pad 1212 is disposed on the edge side of the electronic component 120 (e.g., the first electronic component 121), the solder ball may be prevented from escaping to the outside of the electronic component 120 (e.g., the first electronic component 121) when the soldering material (e.g., the soldering material S of FIG. 5A) connected to the contact point 1211 is melted.

Referring to FIG. 13, as illustrated, the dummy pad 114 may be omitted from the PCB 110. Instead of the dummy pad 114 provided on the PCB 110, the element dummy pad 1212 may serve as the existing dummy pad 114.

When the electronic component 120 is mounted on the substrate at a high density, it may be difficult to dispose a dummy pad (e.g., the dummy pad 114 of FIG. 3B) on the outside of the structural boundary of the electronic component 120 due to the spatial structure. In this case, the dummy pad 1212 may be configured, even on high-density component mounting, by providing the element dummy pad 1212 on the side of the electronic component 120, rather than on the PCB 110.

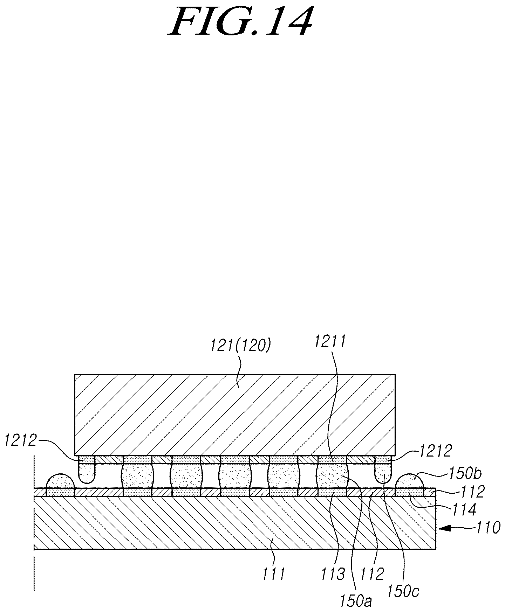

FIG. 14 is a side view illustrating an example printed circuit board assembly according to various embodiments.

The PCB 110 or the electronic component 120 illustrated in FIG. 14 may be included in the PCB assembly 100 of FIG. 1. In the PCB 110 illustrated in FIG. 14, the same reference numerals are assigned to components that are substantially the same as or similar to the PCB 110 illustrated in FIGS. 1 to 3B.

The electronic component 120 (e.g., the first electronic component 121), illustrated in FIG. 14, may be substantially the same as or similar to the electronic component 120 (e.g., the first electronic component 121) illustrated in FIG. 13. The PCB 110 illustrated in FIG. 14 may be substantially the same as or similar to the PCB 110 illustrated in FIG. 3B.

Different from the PCB 110 illustrated in FIG. 13, the PCB 110 of FIG. 14 may have a dual structure by having the element dummy pad 1212 of the electronic component 120 (e.g., the first electronic component 121) and the dummy pad 114.

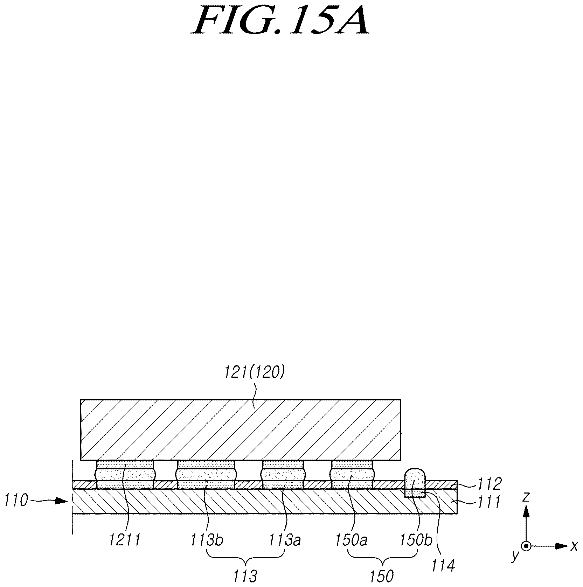

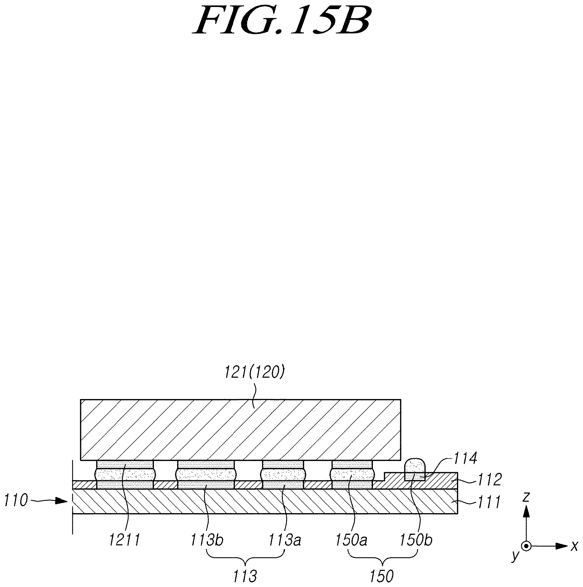

FIGS. 15A and 15B are cross-sectional views illustrating an example substrate according to various embodiments.

The PCB 110 or the electronic component 120 illustrated in FIGS. 15A and 15B may be included in the PCB assembly 100 of FIG. 1. In the PCB 110-7 illustrated in FIGS. 15A and 15B, the same reference numerals are assigned to components that are substantially the same as or similar to the PCB 110 illustrated in FIGS. 1 to 3B.

Referring to FIGS. 15A and 15B, the PCB 110 may include a connection pad 113 (e.g., a first connection pad 113a) and a dummy pad 114 disposed to have different heights.

As illustrated in FIG. 15A, the PCB 110 may have a top-down design structure designed so that a height of the dummy pad 114 is (or sits) lower than a height of the connection pad 113 (e.g., the first connection pad 113a). The dummy pad 114 may be disposed relatively inside the connection pad 113 (e.g., the first connection pad 113a) with respect to the body 111. As illustrated, the dummy pad 114 may be disposed at a lower position than the connection pad 113 (e.g., the first connection pad 113a) (e.g., in the -z-direction). With such a top-down design structure, solder balls may be more efficiently distributed toward the dummy pad 114 in the reflow process.

As illustrated in FIG. 15B, the PCB 110 may have a bottom-up design structure designed so that the height of the dummy pad 114 is (or sits) higher than the connection pad 113 (e.g., the first connection pad 113a). The dummy pad 114 may be disposed relatively outside the connection pad 113 (e.g., the first connection pad 113a) with respect to the body 111. As illustrated, the dummy pad 114 may be disposed at a higher position(or sits higher) than the connection pad 113 (e.g., the first connection pad 113a) (e.g., in the +z-direction). With such a bottom-up design structure, external foreign matter, dust, water or other materials may be prevented more effectively from flowing into the space between the electronic component 120 (e.g., the first electronic component 121) and the PCB 110.

A PCB assembly according to an embodiment may comprise a PCB 110 including a plurality of pads and a dummy pad (114, 910, 920 and 930) and an electronic component 121 including a plurality of contact points 1211 disposed on a bottom side of the electronic component, and the electronic component mounted on the PCB 110 by soldering the plurality of contact points to the plurality of pads. The dummy pad 114, 910, 920, or 930, provided on the PCB 110, may have an elongated portion spaced apart from an outer edge of the electronic component.

According to an embodiment, the dummy pad 114, 910, 920 or 930 may be provided on the PCB 110 for attaching to a portion of solder material detached during the soldering of the plurality of contact points 1211 of the electronic component 121 to the plurality of pads 113 of the PCB 110.

According to an embodiment, the dummy pad 114, 910, 920 or 930 may be configured to extend in a direction parallel to a lateral side of the electronic component 121.

According to an embodiment, the dummy pad 114, 910, 920 or 930 may have a length of 15% to 35% of a length of a lateral side of the electronic component 121 adjacent to the dummy pad 114, 910, 920 or 930.

According to an embodiment, the dummy pad 114, 910, 920, or 930 may be configured to be electrically separated from the plurality of pads 113.

According to an embodiment, the dummy pad 114, 910, 920 or 930 may have a length of 25% to 60% of a length of a lateral side of the electronic component 121 adjacent to the dummy pad 114, 910, 920 or 930.

According to an embodiment, the PCB assembly may further comprise a dummy substrate 140 and a plurality of bridge sections 130 disposed between the PCB 110 and the dummy substrate 140. The soldering of the plurality of contact points 1211 of the electronic component 121 to the plurality of pads 113 of the PCB 110 may be performed while the PCB is attached to the dummy substrate 140 via the plurality of bridge sections 130.

According to an embodiment, the PCB assembly 100 may further comprise at least one bridge section 130 configured to extend to an outside from an edge of the PCB 110 to provide support to the PCB 110.

According to an embodiment, the PCB assembly 100 may further comprise another electronic component 122 mounted on the PCB 110. The electronic component 121 may be disposed to be relatively adjacent to an edge of the PCB 110 than another electronic component 122.

According to an embodiment, the plurality of pads 113 may be disposed to overlap with the electronic component 121.

According to an embodiment, one of the plurality of connection pads 113 may be disposed adjacent to the dummy pad 114, 910, 920, or 930.

According to an embodiment, one pad 113a of the pads 113 may have a ring shape for connection the electronic component 121 including a microphone. The dummy pad 114, 910, 920 or 930 may be disposed adjacent to the one pad 113a having the ring shape.

According to an embodiment, an area of the dummy pad 114, 910, 920 or 930 may be configured to be smaller than an area of one pad 113a adjacent to the dummy pad 114, 910, 920, or 930 among the plurality of pads 113.

According to an embodiment, the dummy pad 910, 920 or 930 may include a body portion 911, 921 or 931, and at least one protrusion 912, 922 or 932 extending toward the electronic component 121.

According to an embodiment, the protrusion 912, 922 or 932 may be extended from the body portion 911, 921 or 931 along the surface of the PCB 110.

According to an embodiment, the at least one protrusion 912, 922, or 932 may be triangular, square, or semicircular shaped.

According to an embodiment, the dummy pad 115-2 may include two elongated parts. The two elongated parts may be joined together and disposed adjacent to a corner of the electronic component 121.

According to an embodiment, the electronic component 121 may be configured to be mounted on the PCB 110 using SMT by soldering the plurality contact points disposed on the bottom side of the electronic component 121 to the plurality of pads 113 disposed on a top side of the PCB 110. The dummy pad 114, 910, 920 or 930, provided on the PCB 110, may be configured to attach to a portion of solder material detached during mounting of the electronic component 121 on the PCB 110 using the SMT process.

According to an embodiment, the PCB 110 may be configured to process solder resist around the dummy pad 114, 910, 920, or 930.

According to an embodiment, the PCB assembly may further include a solder ball 150b disposed on the dummy pad 114, 910, 920 or 930 to be spaced apart from the electronic component 121.

A method of manufacturing a PCB assembly according to an embodiment may comprise providing a dummy pad 114, 910, 920, or 930 on a PCB 110 supported by a dummy substrate 140 via a plurality of bridge sections 130, the PCB including a plurality of pads, applying solder material over each of the plurality of pads 113 on the PCB 110 such that solder material is eccentrically disposed with respect to one of the pads 113 in a direction towards the dummy pad 114, 910, 920, or 930, and mounting an electronic component 121 including a plurality of contact points 1211, disposed on a bottom side of the electronic component 121, on the PCB 110 by soldering the plurality of contact points 1211 to the plurality of pads 113. The dummy pad 114, 910, 920, or 930, provided on the PCB 110, may have an elongated portion spaced apart from an outer edge of the electronic component 121 for attaching to a portion of solder material detached during the soldering of the plurality of contact points 1211 of the electronic component 121 to the plurality of pads of the PCB 110.

According to an embodiment, the plurality of pads 113 and the dummy pad 114, 910, 920 or 930 may be configured to be electrically separated from each other.

According to an embodiment, one pad 113a of the pads 113 may have a ring shape for connection the electronic component including a microphone.

According to an embodiment, a solder ball 150b may be formed on the dummy pad 114, 910, 920 or 930 by melting and reflowing the solder material.

According to an embodiment, the method for manufacturing the PCB assembly may further comprise separating the PCB 110 from the dummy substrate 140 by cutting or severing the plurality of bridge sections 130.

The terms as used herein are provided merely to describe some embodiments thereof but are not intended to limit the disclosure. As used herein, the singular forms "a," "an," and "the" are intended to include the plural forms as well, unless the context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, the term 'and/or' should be understood as encompassing any and all possible combinations by one or more of the enumerated items. As used herein, the terms "include," "have," and "comprise" are used merely to designate the presence of the feature, component, part, or a combination thereof described herein, but use of the term does not exclude the likelihood of presence or adding one or more other features, components, parts, or combinations thereof. As used herein, the terms "first" and "second" may modify various components regardless of importance and/or order and are used to distinguish a component from another without limiting the components.

As used herein, the terms "configured to" may be interchangeably used with the terms "suitable for," "having the capacity to," "designed to," "adapted to," "made to," or "capable of" depending on circumstances. The term "configured to" does not essentially mean "specifically designed in hardware to." Rather, the term "configured to" may mean that a device can perform an operation together with another device or parts. For example, a 'device configured (or set) to perform A, B, and C' may be a dedicated device to perform the corresponding operation or may mean a general-purpose device capable of various operations including the corresponding operation.

Meanwhile, the terms "upper side", "lower side", and "front and rear directions" used in the disclosure are defined with respect to the drawings, and the shape and position of each component are not limited by these terms.

In the disclosure, the above-described description has been made mainly of specific embodiments, but the disclosure is not limited to such specific embodiments but should rather be appreciated as covering all various modifications, equivalents, and/or substitutes of various embodiments.

## Claims

1. A printed circuit board (PCB) assembly comprising:
a PCB (110) including a plurality of pads and a dummy pad (114, 910, 920 or 930); and
an electronic component (121) including a plurality of contact points (1211) disposed on a bottom side of the electronic component, and the electronic component mounted on the PCB (110) by soldering the plurality of contact points to the plurality of pads,
wherein the dummy pad (114, 910, 920 or 930), provided on the PCB (110), has an elongated portion spaced apart from an outer edge of the electronic component (121).

2. The PCB assembly of claim 1,
wherein the dummy pad (114, 910, 920 or 930) is provided on the PCB (110) for attaching to a portion of solder material detached during the soldering of the plurality of contact points (1211) of the electronic component (121) to the plurality of pads (113) of the PCB (110).

3. The PCB assembly of claim 1 or 2,
wherein the dummy pad (114, 910, 920 or 930) is configured to extend in a direction parallel to a lateral side of the electronic component (121).

4. The PCB assembly of any one of claims 1 to 3,
wherein the dummy pad (114, 910, 920 or 930) has a length of 15% to 35% or 25% to 60% of a length of a lateral side of the electronic component (121) adjacent to the dummy pad (114, 910, 920 or 930).

5. The PCB assembly of any one of claims 1 to 4, further including:
a dummy substrate (140); and
a plurality of bridge sections (130) disposed between the PCB (110) and the dummy substrate (140),
wherein the soldering of the plurality of contact points (1211) of the electronic component (121) to the plurality of pads (113) of the PCB (110) is performed while the PCB is attached to the dummy substrate (140) via the plurality of bridge sections (130).

6. The PCB assembly of any one of claims 1 to 5,
further comprising another electronic component (122) mounted on the PCB (110),
wherein the electronic component (121) is disposed to be relatively adjacent to an edge of the PCB (110) than the another electronic component (122).

7. The PCB assembly of any one of claims 1 to 6,
wherein the plurality of pads (113) is disposed to overlap with the electronic component (121).

8. The PCB assembly of any one of claims 1 to 7,
wherein one pad (113a) of the plurality of pads (113) has a ring shape for connection the electronic component (121),
wherein the dummy pad (114, 910, 920 or 930) is disposed adjacent to the one pad (113a) having the ring shape.

9. The PCB assembly of any one of claims 1 to 8,
wherein an area of the dummy pad (114, 910, 920 or 930) is configured to be smaller than an area of one pad (113a) adjacent to the dummy pad (114, 910, 920 or 930) among the plurality of pads (113).

10. The PCB assembly of any one of claims 1 to 9,
wherein the dummy pad (910, 920 or 930) includes a body portion (911, 921 or 931), and at least one protrusion (912, 922 or 932) extending toward the electronic component (121),
wherein the protrusion (912, 922 or 932) is extended from the body portion (911, 921 or 931) along the surface of the PCB (110).

11. The PCB assembly of any one of claims 1 to 9,
wherein a dummy pad (115-2) comprises two elongated parts, wherein the two elongated parts joined together and disposed adjacent to a corner of the electronic component (121).

12. The PCB assembly of any one of claims 1 to 11,
wherein the electronic component (121) is configured to be mounted on the PCB (110) using Surface Mount Technology (SMT) by soldering the plurality contact points disposed on the bottom side of the electronic component (121) to the plurality of pads (113) disposed on a top side of the PCB (110),
wherein the dummy pad (114, 910, 920 or 930), provided on the PCB (110), is configured to attach to a portion of solder material detached during mounting of the electronic component (121) on the PCB (110) using SMT process.

13. The PCB assembly of any one of claims 1 to 12,
wherein the PCB assembly further includes a solder ball (150b) disposed on the dummy pad (114, 910, 920 or 930) to be spaced apart from the electronic component (121).

14. A method of manufacturing a printed circuit board (PCB) assembly, the method comprising:
providing a dummy pad on the PCB supported by a dummy substrate via a plurality of bridge sections, the PCB including a plurality of pads which are configured to be electrically separated from the dummy pad;
applying solder material over each of the plurality of pads on the PCB such that solder material is eccentrically disposed with respect to one of the pads in a direction towards the dummy pad; and
mounting an electronic component (121) including a plurality of contact points (1211), disposed on a bottom side of the electronic component, on the PCB by soldering the plurality of contact points to the plurality of pads and forming a solder ball(150b) formed on the dummy pad (114, 910, 920 or 930),
wherein the dummy pad, provided on the PCB, has an elongated portion spaced apart from an outer edge of the electronic component for attaching to a portion of solder material detached during the soldering of the plurality of contact points of the electronic component to the plurality of pads of the PCB.

15. The manufacturing method of the PCB assembly of claim 14,
wherein one pad (113a) of the pads (113) has a ring shape for connection the electronic component.
